# EUROPEAN PATENT APPLICATION

(11) **EP 4 694 606 A1**
(43) Date of publication of application: **11.02.2026**
(21) Application number: 24780890.0
(22) Date of filing: 29.03.2024
(51) Int. Cl.: H05K 9/00, C08G 65/333, C08J 5/18, C08L 101/02

(54) **RADIO WAVE SHIELDING BODY AND ADHESIVE COMPOSITION**

(30) Priority: 31.03.2023 JP 2023059329
(71) Applicant: Zeon Corporation, Tokyo 100-8246 (JP)
(72) Inventor: YONEMARU, Hiroyuki, Tokyo 100-8246 (JP)
(74) Representative: Maiwald GmbH
(86) International application number: PCT/JP2024/013253
(87) International publication number: WO 2024/204796

(57) **Abstract**

Provided is a radio wave shielding body comprising a cationic group-containing polymer having a cationic group in the polymer chain. Provided is an adhesive composition comprising a cationic group-containing polymer having a cationic group in the polymer chain and water, wherein the content of the cationic group-containing polymer in the adhesive composition is 55% by weight or more and 95% by weight or less, and the content of the water in the adhesive composition is 5% by weight or more and 45% by weight or less.

## Description

### TECHNICAL FIELD

The present invention relates to a radio wave shielding body comprising a cationic group-containing polymer having a cationic group in the polymer chain. The present invention also relates to an adhesive composition comprising a cationic group-containing polymer having a cationic group in the polymer chain.

### BACKGROUND ART

It is known that composite materials including an insulating material, such as a resin, and a conductive material compounded therewith are used as electromagnetic wave absorption materials in the electrical field, the communication field, and the like.

For example, Patent Document 1 suggests an electromagnetic wave absorption material comprising fibrous carbon nanostructures and an insulating material, wherein a content C of the fibrous carbon nanostructures when a content of the insulating material is 100 parts by mass is 5 parts by mass or more and 15 parts by mass or less, or, in the case where the fibrous carbon nanostructures are fibrous carbon nanostructures that exhibit a convex upward shape in a t-plot obtained from an adsorption isotherm, the content C is 0.3 parts by mass or more and 0.8 parts by mass or less, and the electromagnetic wave absorption material absorbs an electromagnetic wave in a frequency domain of more than 20 GHz.

The technique disclosed in Patent Document 1 is a technique of absorbing a radio wave or an electromagnetic wave due to action of fibrous carbon nanostructures by virtue of the fibrous carbon nanostructures contained in an insulative polymer as the insulating material, and the insulative polymer as the insulating material is used to hold the fibrous carbon nanostructures in a predetermined shape. That is, the technique disclosed in Patent Document 1 is not a technique of absorbing a radio wave or an electromagnetic wave with an insulative polymer as the insulating material.

### RELATED ART DOCUMENTS

### PATENT DOCUMENTS

Patent Document 1: WO 2017/110096

### SUMMARY OF THE INVENTION

### PROBLEM TO BE SOLVED BY THE INVENTION

An object of the present invention is to provide a radio wave shielding body having excellent radio wave shielding properties.

Another object of the present invention is to provide an adhesive composition which can demonstrate high adhesiveness and strength and allow easy removal after it is used.

### MEANS FOR SOLVING PROBLEMS

The present inventor, who has conducted extensive research to achieve the above objects, has found that a cationic group-containing polymer having a cationic group in the polymer chain has excellent radio wave shielding properties, and has completed the present invention.

The present inventor has also found that a composition containing a cationic group-containing polymer having a cationic group in the polymer chain and water in specific proportions can demonstrate high adhesiveness and strength and allow easy removal after it is used, and has completed the present invention.

Specifically, the present invention relates to the followings.
[1] A radio wave shielding body comprising a cationic group-containing polymer having a cationic group in the polymer chain.
[2] The radio wave shielding body according to [1], wherein the radio wave shielding body contains the cationic group-containing polymer in a proportion of 1 to 100% by weight.
[3] The radio wave shielding body according to [1] or [2], wherein the radio wave shielding body shields radio waves at a frequency of 1 GHz or more and 300 THz or less.
[4] The radio wave shielding body according to any one of [1] to [3], further comprising an exterior member.
[5] A sheet comprising the radio wave shielding body according to any one of [1] to [4].
[6] A partition member comprising the radio wave shielding body according to any one of [1] to [4].
[7] The partition member according to [6], wherein the partition member is a divider, a humidity conditioner, a thermal barrier, a curtain, a window, a wall material, eyeglasses, a housing for an electrical circuit product, or a member used in an inside of an electrical circuit product.
[8] A sealing material comprising the radio wave shielding body according to any one of [1] to [4].
[9] An adhesive composition comprising a cationic group-containing polymer having a cationic group in the polymer chain, and water,
   wherein the content of the cationic group-containing polymer in the adhesive composition is 55% by weight or more and 95% by weight or less, and the content of the water in the adhesive composition is 5% by weight or more and 45% by weight or less.
[10] The adhesive composition according to [9], wherein the adhesive composition is capable of absorbing water in a weight five times or more the weight of the cationic group-containing polymer, thereby making the cationic group-containing polymer swellable or soluble in water.
[11] The adhesive composition according to [9] or [10], wherein the adhesive composition is curable by performing at least one of polymerization and cross-linking.
[12] A molded body obtained by forming a gel of the adhesive composition according to any one of [9] to [11].
[13] The molded body according to [12], wherein the molded body is capable of absorbing water in a weight five times or more the weight of the cationic group-containing polymer, thereby making the cationic group-containing polymer swellable or soluble in water.
[14] An adhesive comprising the adhesive composition according to any one of [9] to [11] or the molded body according to [12] or [13].
[15] A composite material obtained by bonding with the adhesive according to [14].
[16] A composite formation method of forming a first material and second material into a composite by performing at least one of polymerization and cross-linking in a state where the adhesive composition according to [11] is in contact with the first material and the second material.

### EFFECTS OF THE INVENTION

The present invention provides a radio wave shielding body having high radio wave shielding performance, and a sheet, a partition member, and a sealing material including such a radio wave shielding body.

The present invention also provides an adhesive composition which can demonstrate high adhesiveness and strength and allow easy removal after it is used, and provides a molded body, an adhesive, and a composite material comprising such an adhesive composition, and a composite formation method.

### BRIEF DESCRIPTION OF DRAWINGS

[Fig. 1] Fig. 1 is a graph of the reflection attenuation amount and transmission attenuation amount in the gigahertz range in Example 3.
[Fig. 2] Fig. 2 is a graph of the absorption rate in the gigahertz range in Example 3.
[Fig. 3] Fig. 3 is a graph of transmittance of visible light in Example 4 and Comparative Example 1.

### DESCRIPTION OF EMBODIMENTS

The radio wave shielding body according to the present invention comprises a cationic group-containing polymer having a cationic group in the polymer chain.

The radio wave shielding body according to the present invention has excellent radio wave shielding properties, and more specifically, has excellent radio wave absorbing or blocking properties. In particular, the present inventor, who has conducted extensive research to achieve excellent radio wave shielding properties, has found that a cationic group-containing polymer having a cationic group in the polymer chain has excellent radio wave shielding properties, more specifically, has excellent radio wave absorbing properties and/or radio wave blocking properties, and has completed the present invention based on such a knowledge.

Here, as radio wave absorbing materials, conductive carbon materials, ceramic materials having magnetism, and the like are known. As radio wave blocking-off materials, metals are known. On the other hand, carbon materials, ceramic materials, and metal materials all are opaque materials, hard materials, and heavy materials with high specific gravity. These lead to limitations to the degree of improvement or the form to be implemented, although from the viewpoint of implementing radio wave absorbing properties and/or radio wave blocking properties using carbon materials, ceramic materials, and metal materials, properties of the radio wave shielding body can be improved by significantly reducing the thickness of the radio wave shielding body, producing a radio wave shielding body formed from a layer of fibers or fine particles such as powder, or the like. For this reason, a soft material, a transparent material, a lightweight material, or the like has been demanded as the radio wave shielding body.

To enhance the radio wave blocking-off performance, a structured body called λ/4 type may be used in some cases. In a A/4 type structure, radio wave blocking-off performance is implemented by a difference in phase between an incident radio wave and a reflected radio wave. For example, examples of a polymer material having radio wave shielding properties using a A/4 type structure include that disclosed in JP 2022-165989 A. Since the technique disclosed in JP 2022-165989 A is a technique in which a polymer material is used, it is considered that the technique can implement lightweightness and high flexibility. However, when the A/4 type structure used in the technique disclosed in JP 2022-165989 A or the like is used, the polymer material should be formed into a sheet shape in order to implement high radio wave shielding properties, and the shape thereof is limited. When the λ/4 type structure is used, the λ/4 type structure exhibits high frequency-specificity because absorption is implemented by shifting the phase of the reflected wave by 1/2 wavelength with respect to the incident wave to cancel each other. Thus, while the A/4 type structure exhibits high absorption performance at the target frequency, it cannot absorb radio waves with frequencies other than the targe frequency. Furthermore, because the λ/4 type structure is basically designed for incidence of a radio wave from a vertical direction, it shows reduced absorption performance for radio waves entering in a tilted direction. In other words, in the radio wave shielding body including a λ/4 type structure, radio wave shielding properties in a broad frequency range and/or shielding properties against radio waves from a wide angle cannot be implemented. In addition, the wavelength to be absorbed by the radio wave shielding body including the A/4 type structure varies depending on the thickness thereof, and thus, the absorption performance varies depending on the fluctuation of the thickness of the radio wave shielding body when produced. For this reason, it is difficult to obtain a radio wave shielding body exhibiting favorable shielding properties to a desired wavelength. In particular, when the λ/4 type structure is used to implement absorbing properties to a gigahertz or higher range of frequencies, the radio wave shielding body should have a thickness of about several hundreds micrometers. For this reason, the above-mentioned problem becomes more prominent. Furthermore, when the radio wave shielding body is used, the thickness thereof may be changed by damage or dirt with dust or the like, leading to a reduction in absorption performance in some cases. In addition, a conductive layer is needed to form a λ/4 type structure, and a metal foil or the like is used to form such a conductive layer. Thus, transparency cannot be guaranteed in most of such cases.

In contrast, the present inventor, who has conducted extensive research, has found that a reduction in radio wave shielding performance caused by a fluctuation of the thickness is suppressed by a cationic group-containing polymer having a cationic group in the polymer chain because the polymer itself exhibits excellent radio wave shielding properties (excellent radio wave absorbing properties and/or radio wave blocking properties), the radio wave shielding performance is demonstrated even in a frequency range of infrared light, which corresponds to heat rays, excellent transmissivity in a frequency range of visible light is provided, and thus, a lightweight material having high stretchability, flexibility, and transparency is obtained without using a A/4 type structure. These findings have led to completion of the present invention.

The radio wave shielding body according to the present invention can control a radio wave by absorbing or reflecting the radio wave, and can be used in change of the direction of a radio wave by reflecting the radio wave, blocking of unnecessary radio waves, a suppression in electromagnetic noises, and the like, for example. Specifically, the radio wave shielding body according to the present invention does not use radio wave interference, but the material itself absorbs radio waves. Thus, the attenuation amount of a radio wave increases rather than reduces, even when radio waves enter in tilted directions. In addition, the radio wave shielding body according to the present invention comprises a cationic group-containing polymer having a cationic group in the polymer chain, and the cationic group-containing polymer has low flammability. For these reasons, even when heat is generated as a result of absorption of a radio wave, ignition caused by heat generation or the like can be suppressed, and thereby, high safety can be implemented. Furthermore, because the radio wave shielding body according to the present invention comprises a cationic group-containing polymer having a cationic group in the polymer chain, it also has high lightfastness.

In the present invention, the radio wave is a concept encompassing electromagnetic waves, and includes radio waves or electromagnetic waves with a frequency ranging from 10³ Hz to 10¹⁶ Hz. The radio wave shielding body according to the present invention shields or blocks off radio waves or electromagnetic waves, and shields or blocks off radio waves or electromagnetic waves with a mode in which a radio wave or an electromagnetic wave is reflected, a mode in which a radio wave or an electromagnetic wave is absorbed (mode in which a radio wave or an electromagnetic wave is subjected to transmission attenuation by absorption), and a combination thereof.

The radio wave shielding body according to the present invention can suitably shield radio waves with a frequency of 1 GHz or more and 300 THz or less, more suitably shield radio waves with a frequency of 5.6 GHz or more and 250 THz or less, still more suitably shield radio waves with a frequency of 10 GHz or more and 200 THz or less.

It is sufficient that the cationic group-containing polymer having a cationic group in the polymer chain (hereinafter, appropriately referred to as "cationic group-containing polymer") used in the present invention is a polymer having a cationic group in the polymer chain, and it is not particularly limited. It may be a polymer having a cationic group in the main chain of the polymer, may be a polymer having a cationic group in the side chain of the polymer, or further, may be a polymer having a cationic group of the main chain and side chain of the polymer.

Examples of the cationic group contained in the cationic group-containing polymer used the present invention include, but are not particularly limited to, cationic groups containing a nitrogen, phosphorus, sulfur, or oxygen atom as the central atom. Among these, preferred are cationic groups containing a nitrogen atom as the central atom from the viewpoint of the radio wave shielding performance. A preferred cationic structure is preferably the following structure (I) or (II). Specifically, examples thereof include ammonium, iminium, imidazolium, pyridinium, and the like. As a preferred substituent for the cationic group, two or more groups having two or more atoms are bonded. The cationic group-containing polymer used in the present invention may have an anionic group in the polymer chain in addition to the cationic group, and may have a betaine structure or the like, for example.

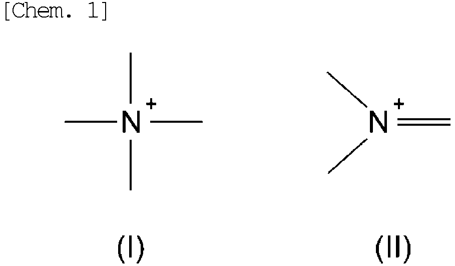

In addition to the cationic group, the cationic group-containing polymer used in the present invention preferably has a polar atom other than the cationic group. When such a polar atom is contained, the positive charge of the cation can be neutralized to give better dissociative properties to the anion. This can further enhance the radio wave shielding performance, and also improves transparency and flexibility. Such a polar atom include an oxygen atom and a nitrogen atom. Examples of groups having such a polar atom include, but are not particularly limited to, an ether bond, a ketone group, a carboxyl group, a hydroxyl group, an amine group, an amide bond, a urethane bond, a urea bond, and the like. The imidazolium structure has another nitrogen atom in the imidazolium ring in addition to the cationic nitrogen atom. Such another nitrogen atom can be also regarded as the polar atom other than the cationic group.

For the cationic group-containing polymer, examples of cationic group-containing polymers having a cationic group in the side chain include addition polymerized products of vinyl compounds, polyether, polyethyleneimine, polyoxazoline, and the like, and examples of cationic group-containing polymers having a cationic group in the main chain include ionenes, epichlorohydrin-amine condensates, polyamide polyamine epichlorohydrin, and the like. These may have any other substituent, or may be those in which part of hydrogen atoms is substituted by a halogen atom such as fluorine. The cationic group-containing polymer may also be the one obtained by copolymerizing the structural unit having a cationic group with a structural unit derived from a monomer having no cationic group, or may be the one having a pH controlled by introducing a structural unit derived from an acidic monomer or a structural unit derived from a basic monomer.

The cationic group-containing polymer used in the present invention has such a cationic group in the polymer chain, and examples of counter anions to the cationic group include, but are not particularly limited to, imides such as fluorosulfonylimide, bis(trifluoromethylsulfonyl)imide, and bis(pentafluoroethylsulfonyl)imide; halogens such as chlorides and bromides; tetrafluoroboric acid, hexafluorophosphoric acid, dicyanoamide, tetracyanoborate, carbonic acid, alkylcarbonic acids, triflate, perchloric acid, nitric acid, sulfuric acid, alkylsulfuric acids, sulfonic acid, phosphoric acid, alkylphosphoric acids; and the like.

The cationic group-containing polymer used in the present invention is not particularly limited, and examples of the polymer having a cationic group in the side chain of the polymer include, but are not particularly limited to, a cationic group-containing polyether (A) including a repeating unit represented by General Formula (1) below. 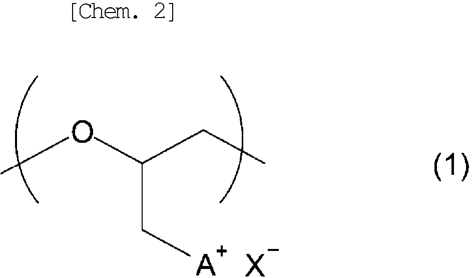 (where in General Formula (1) above, A⁺ represents a nitrogen-containing cationic group; and in General Formula (1) above, X⁻ represents an anion) .

Examples of the nitrogen-containing cationic group represented by A⁺ include an amino group, nitrogen-containing cationic aromatic groups, and nitrogen-containing cationic aliphatic groups.

Nitrogen-containing cationic aromatic groups for A⁺ are preferably groups containing a cationic nitrogen-containing aromatic heterocycle. It is sufficient that the nitrogen-containing aromatic heterocycle for the cationic nitrogen-containing aromatic heterocycle in the groups containing a cationic nitrogen-containing aromatic heterocycle has a nitrogen atom in the ring and has aromaticity. The nitrogen-containing aromatic heterocycle may have a heteroatom other than the nitrogen atom, such as an oxygen atom or a sulfur atom, or part of atoms contained in the heterocycle may be substituted by a substituent. The nitrogen-containing aromatic heterocycle may have a polycyclic structure formed from two or more rings fused. Examples of such a structure of the nitrogen-containing aromatic heterocycle include five-membered heterocycles such as an imidazole ring, a pyrrole ring, a thiazole ring, an oxazole ring, a pyrazole ring, and an isooxazole ring; six-membered heterocycles such as a pyridine ring, a pyrazine ring, a pyrimidine ring, a pyridazine ring, and a triazine ring; fused heterocycles such as a quinoline ring, an isoquinoline ring, a quinoxaline ring, a quinazoline ring, a cinnoline ring, a purine ring, an indole ring, an isoindole ring, a benzimidazole ring, a benzooxazole ring, and a benzoisooxazole ring; and the like. Among these, preferred are five-membered heterocycles and six-membered heterocycles, and more preferred is an imidazole ring.

Examples of substituents for the nitrogen-containing aromatic heterocycle include, but are not particularly limited to, alkyl groups; cycloalkyl groups; alkenyl groups such as a vinyl group; aryl groups such as a phenyl group; arylalkyl groups; alkylaryl groups; alkoxyl groups; alkoxyalkyl groups; aryloxy groups; alkanol groups; a hydroxyl group; a carbonyl group; an alkoxycarbonyl groups; an amino group; an imino group; a nitrile group; alkylsilyl groups; halogen atoms; and the like. These substituents have preferably 0 to 12, more preferably 1 to 8, still more preferably 1 to 6 carbon atoms.

The nitrogen-containing cationic aliphatic group for A⁺ may be straight-chained or branched-chained, or may have a non-aromatic ring structure.

Specific examples of the nitrogen-containing cationic group represented by A⁺ include an ammonium group; cationic monosubstituted ammonium groups containing a nitrogen atom, such as a methylammonium group, a butylammonium group, a cyclohexylammonium group, an anilinium group, a benzylammonium group, and an ethanolammonium group; cationic disubstituted ammonium groups containing a nitrogen atom such as a dimethylammonium group, a diethylammonium group, a dibutylammonium group, and a nonylphenylammonium group; cationic trisubstituted ammonium groups containing a nitrogen atom such as a trimethylammonium group, a triethylammonium group, a n-butyldimethylammonium group, a stearyldimethylammonium group, a tributylammonium group, a trivinylammonium group, a triethanolammonium group, an N,N-dimethylethanolammonium group, and a tri(2-ethoxyethyl)ammonium group; cationic heterocyclic groups containing a nitrogen atom, such as a piperidinium group, a 1-methylpyrrolidinium group, a 1-butylpyrrolidinium group, an imidazolium group, a 1-methylimidazolium group, a 1-ethylimidazolium group, a 1-butyl-imidazolium group, a benzimidazolium group, a pyrrolium group, a 1-methylpyrrolium group, an oxazolium group, a benzoxazolium group, a pyrazolium group, an isooxazolium group, a pyridinium group, a 2,6-dimethylpyridinium group, a pyrazinium group, a pyrimidinium group, a pyridazinium group, a triazinium group, an N,N-dimethyl anilinium group, a quinolinium group, an isoquinolinium group, an indolinium group, a quinoxalium group, and an isoquinoxalium group; and the like. Among these, preferred are cationic trisubstituted ammonium groups containing a nitrogen atom and cationic heterocyclic groups containing a nitrogen atom.

In General Formula (1) above, the anion represented by X⁻ is a counter anion for the nitrogen-containing cationic group represented by A⁺. Examples of monovalent anions for X⁻ include halide ions such as F⁻, Cl⁻, Br⁻, and I⁻; sulfonyl imidide ions such as (FSO₂)₂N⁻, (CF₃SO₂)₂N⁻, and (CF₃CF₂SO₂)₂N⁻; carboxylate ions such as CH₃COO⁻, C₃H₇COO⁻, CF₃COO⁻, and PhCOO⁻(where Ph represents a phenyl group); sulfonate ions such as CH₃SO₃⁻ and CF₃SO₃⁻; OH⁻, BF₄⁻, PF₆⁻, ClO₄⁻, B(CN)₄⁻, SCN⁻, (NC)₂N⁻, and the like. X⁻ may be a polyvalent anion, or may be a polyanion having two or more monovalent anionic groups in the molecule. Examples of the polyvalent anion include sulfate ions (SO₄²⁻) and carbonate ions (CO₃²⁻). Examples of the polyanion having two or more monovalent anionic groups in the molecule include⁻O₃SCF₂CF₂CF₂SO₃⁻, ⁻O₃SCF₂CF₂SO₃⁻, CF₃SO₂N⁻SO₂CF₂CF₂OCF₂CF₂OCF₂CF₂SO₂N⁻SO₂CF₃, and the like. Among these, preferred are sulfonyl imidide ions, carboxylate ions, and BF₄⁻, and more preferred are sulfonyl imidide ions, CH₃COO⁻, and BF₄⁻ from the viewpoint of the radio wave shielding properties.

In the cationic group-containing polyether (A) used in the present invention, the units represented by General Formula (1) above may be each independent, and two or more units represented by General Formula (1) may be present in the cationic group-containing polyether (A). For example, in the entire repeating units represented by General Formula (1) in the cationic group-containing polyether (A), all the nitrogen-containing cationic groups represented by A⁺ may be the same nitrogen-containing cationic group, or different nitrogen-containing cationic groups may be present. In the entire repeating units represented by General Formula (1) in the cationic group-containing polyether (A), all the anions represented by X⁻ may be the same anion, and different anions may be present.

Examples of the repeating units represented by General Formula (1) above include a repeating unit represented by General Formula (2). The repeating unit represented by General Formula (2) below is an oxirane unit having an imidazolium structure: 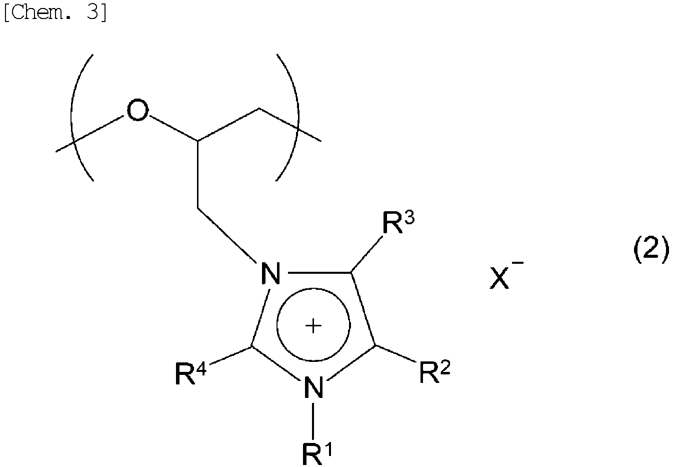 (where in General Formula (2) above, R¹ to R⁴ each independently represent a hydrogen atom or a substituent, and R² and R³ may be bonded to each other; and in General Formula (2), X⁻ represents an anion).

In General Formula (2) above, R¹ to R⁴ each independently represent a hydrogen atom or a substituent. Examples of the substituent include the same substituents as those for the nitrogen-containing aromatic heterocycle listed above. The substituents for R¹ to R⁴ may be straight-chained or branched-chained, or may have a ring structure. The substituents for R¹ to R⁴ are preferably straight-chained.

In General Formula (2) above, it is sufficient that R¹ is a hydrogen atom or a substituent. Although R¹ is not particularly limited, R¹ is preferably a hydrogen atom or a hydrocarbon group, more preferably a hydrocarbon group, still more preferably an alkyl group or an alkenyl group, particularly preferably an alkyl group or a vinyl group, most preferably an alkyl group. R¹ has preferably 0 to 12, more preferably 0 to 8, still more preferably 1 to 6, further still more preferably 1 to 4, particularly preferably 1 to 3, most preferably 1 to 2 carbon atoms.

In General Formula (2) above, it is sufficient that R² to R⁴ are each independently a hydrogen atom or a substituent. Although R² to R⁴ are not particularly limited, it is preferred that R² to R⁴ be each independently a hydrogen atom or a hydrocarbon group, more preferred that R² to R⁴ be each independently a hydrogen atom, an alkyl group, or a vinyl group, still more preferred that R² to R⁴ be each independently a hydrogen atom or an alkyl group, and particularly preferred that R² to R⁴ be each independently a hydrogen atom. R² to R⁴ each independently have preferably 0 to 8 carbon atoms, more preferably 0 to 6 carbon atoms, still more preferably 0 to 4 carbon atoms, further still more preferably 0 to 3 carbon atoms, particularly preferably 0 to 2 carbon atoms, most preferably 0 to 1 carbon atom.

In General Formula (2) above, it is preferred that 1 to 3 of R² to R⁴ represent a hydrogen atom, and it is more preferred that 2 to 3 of R² to R⁴ represent a hydrogen atom. It is preferred that 0 to 2 of R² to R⁴ represent a substituent such as a hydrocarbon group, and it is more preferred that 0 to 1 of R² to R⁴ represent a substituent such as a hydrocarbon group.

Examples of the anion represented by X⁻ in General Formula (2) above include the same anions as those represented by X⁻ in General Formula (1), and suitable examples are as described above.

The repeating unit represented by General Formula (2) above preferably contains an imidazolium group, a 1-methylimidazolium group, a 1-butylimidazolium group, a 1-hexylimidazolium group, or a 1-vinylimidazolium group, and more preferably contains a 1-methylimidazolium group.

The cationic group-containing polyether (A) used in the present invention may contain a repeating unit other than the above-mentioned repeating units represented by General Formula (1). It is sufficient that the repeating unit other than the repeating units represented by General Formula (1) is a unit derived from a monomer copolymerizable with monomers which give the repeating units represented by General Formula (1). Examples thereof include, but are not particularly limited to, alkylene oxide monomer units such as an ethylene oxide unit, a propylene oxide unit, a 1,2-butylene oxide unit, and a 1,2-octylene oxide unit; aromatic oxirane monomer units such as a styrene oxide unit; epihalohydrin monomer units such as an epichlorohydrin unit, an epibromohydrin unit, and an epiiodohydrin unit; alkenyl group-containing oxirane monomer units such as an allyl glycidyl ether unit; aromatic ether group-containing oxirane monomer units such as a phenyl glycidyl ether unit; (meth)acryloyl group-containing oxirane monomer units such as a glycidyl acrylate unit and a glycidyl methacrylate unit; and the like. Among these, preferred are alkylene oxide monomer units, epihalohydrin monomer units, and (meth)acryloyl group-containing oxirane monomer units, and more preferred are an ethylene oxide unit, a propylene oxide unit, an epichlorohydrin unit, and a glycidyl methacrylate unit. The cationic group-containing polyether (A) used in the present invention may contain only one or two or more of these repeating units other than the repeating units represented by General Formula (1).

The cationic group-containing polyether (A) used in the present invention may contain two or more types of repeating units. In this case, although a distribution pattern of those repeating units is not particularly limited, the repeating units preferably have a random distribution.

The chain structure of the cationic group-containing polyether (A) used in the present invention is not particularly limited, and may be a straight-chained structure, or may have a branched-chain structure such as a graft-branched structure or a radially branched structure.

The end group of the cationic group-containing polyether (A) used in the present invention is not particularly limited, and can be any monovalent group. Specific examples of groups as the end group include a hydrogen atom, halogen groups, alkyl groups, haloalkyl groups, a hydroxyl group, an azide group, and the like. The group as the end group may be a group formed from a nitrogen-containing cationic group (A⁺) and an anion (X⁻) contained in the repeating unit represented by General Formula (1).

The content of the repeating unit represented by General Formula (1) in the cationic group-containing polyether (A) used in the present invention is not particularly limited, and the average number of repeating units in one molecule is preferably 1 to 100,000, more preferably 3 to 50,000, still more preferably 10 to 30,000, particularly preferably 30 to 10,000.

The cationic group-containing polyether (A) used in the present invention has a weight average molecular weight (Mw) of preferably 750 to 2,000,000, more preferably 2,000 to 1,500,000, still more preferably 4,000 to 1,000,000, preferably particularly 10,000 to 500,000, although not particularly limited thereto.

The cationic group-containing polyether (A) used in the present invention has a molecular weight distribution (Mw/Mn) of preferably 1.0 to 4.0, more preferably 1.0 to 2.0, still more preferably 1.0 to 1.5, although not particularly limited thereto.

The weight average molecular weight, and molecular weight distribution of the cationic group-containing polyether (A) can be determined by methods described in Examples below. The molecular weight distribution of the cationic group-containing polyether (A) can be treated as the molecular weight distribution which does not change from that of the base polymer before the cationic group is introduced (polyether without a cationic group).

More preferably, the proportion of the repeating unit represented by General Formula (1) in the cationic group-containing polyether (A) used in the present invention is preferably 5 to 100 mol%, more preferably 10 to 100 mol% in the total repeating units in the cationic group-containing polyether (A), although not particularly limited thereto.

A method of synthesizing the cationic group-containing polyether (A) used in the present invention is not particularly limited, and any synthesis method can be used as long as it can give the target polyether compound. As one example of the synthesis method, first, a base polymer (polyether without a cationic group) is obtained by the following method (α) or (β).
(α) A method of obtaining a base polymer, including ring-opening polymerization of an oxirane monomer-containing monomer that contains at least epihalohydrin such as epichlorohydrin, epibromohydrin, and epiiodohydrin, in the presence of a catalyst that contains an onium salt of a compound containing an atom from Group 15 or 16 of the periodic table and a trialkylaluminum in which alkyl groups contained are all straight-chained alkyl groups, which catalyst is disclosed in JP 2010-53217 A.
(β) A method of obtaining a base polymer, including ring-opening polymerization of an oxirane monomer-containing monomer that contains at least epihalohydrin such as epichlorohydrin, epibromohydrin, and epiiodohydrin, in the presence of a catalyst prepared by the reaction of triisobutylaluminum with phosphoric acid and triethylamine, which catalyst is disclosed in JP 46-27534 B.

Then, through a reaction (onium formation reaction) of halogen groups contained in the epihalohydrin monomer units of the base polymer obtained by the method (α) or (β) with an onium-forming agent containing a nitrogen-containing cationic group, at least part of the halogen groups contained in the epihalohydrin monomer units of the base polymer is converted to an onium halide group containing the nitrogen-containing cationic group, thereby obtaining an onium halide structural unit-containing polyether compound containing a repeating unit represented by General Formula (1) where the anion (X⁻) is a halide ion. Further, the resulting onium halide structural unit-containing polyether compound is reacted with a salt of an anion (X⁻) other than the halide ion and a metal cation, as needed, to perform an anion-exchange reaction. Thereby, the halide ion contained in the onium halide group containing the nitrogen-containing cationic group can be converted to the anion (X⁻) other than the halide ion.

The onium-forming agent containing the nitrogen-containing cationic group used for the reaction of the base polymer with the onium-forming agent containing the nitrogen-containing cationic group is an onium-forming agent corresponding to the nitrogen-containing cationic group (A⁺) in General Formula (1). For example, the repeating unit represented by General Formula (2) can be formed by using an imidazole compound corresponding to the imidazolium structure in General Formula (2) as the onium-forming agent.

The method of reacting the base polymer with the onium-forming agent is not particularly limited, and is preferably a method of mixing the base polymer with the onium-forming agent. Examples of the method of mixing the base polymer with the onium-forming agent include, but are not particularly limited to, a method of adding and mixing the onium-forming agent to and with a solution containing the base polymer, a method of adding and mixing the base polymer to and with a solution containing the onium-forming agent, a method of separately preparing a solution of the onium-forming agent and a solution of the base polymer, and mixing these solutions, and the like.

Solvents suitably used for the reaction of the base polymer with the onium-forming agent are inert solvents, and may be nonpolar or polar. Examples of such nonpolar solvents include aromatic hydrocarbons such as benzene and toluene; chain saturated hydrocarbons such as n-pentane and n-hexane; alicyclic saturated hydrocarbons such as cyclopentane and cyclohexane; and the like. Examples of such polar solvents include ethers such as tetrahydrofuran, anisole, and diethyl ether; esters such as ethyl acetate and ethyl benzoate; ketones such as acetone, 2-butanone, and acetophenone; aprotic polar solvents such as acetonitrile, dimethylformamide, dimethylacetamide, and dimethyl sulfoxide; protic polar solvents such as ethanol, methanol, and water; and the like. As the solvent, mixed solvents of these are suitably used. The amount of the solvent to be used is not particularly limited, and the solvent is used such that the concentration of the base polymer is preferably 1 to 50% by mass, more preferably 3 to 40% by mass.

The amount of the onium-forming agent to be used for the reaction of the base polymer with the onium-forming agent is not particularly limited, and can be determined according to the content of the repeating units represented by General Formula (1) of the intended polyether compound. Specifically, the amount of the onium-forming agent to be used is in the range of usually 0.01 to 100 moles, preferably 0.02 to 50 moles, more preferably 0.03 to 10 moles, still more preferably 0.05 to 2 moles relative to 1 mole of the epichlorohydrin units in the base polymer.

The pressure for the reaction of the base polymer with the onium-forming agent is not particularly limited, and is usually 1 to 500 atm, preferably 1 to 100 atm, particularly preferably 1 to 50 atm. The temperature for the reaction is also not particularly limited, and is usually 0 to 200°C, preferably 20 to 170°C, more preferably 40 to 150°C. The reaction time is usually 1 minute to 1,000 hours, preferably 3 minutes to 800 hours, more preferably 5 minutes to 500 hours, still more preferably 30 minutes to 200 hours.

A method of reacting the onium halide structural unit-containing polyether compound with the salt of the anion (X⁻) other than the halide ion and a metal cation to perform an anion-exchange reaction is not particularly limited. Preferred is a method of mixing the onium halide structural unit-containing polyether compound with the salt of the anion (X⁻) other than the halide ion and a metal cation, and reacting these.

For the anion-exchange reaction, the reaction condition is not particularly limited. The onium halide structural unit-containing polyether compound may be mixed only with the salt of the anion (X⁻) other than the halide ion and a metal cation, or the anion-exchange reaction may be performed under a condition where a different compound such as an organic solvent is present. The amount of the salt to be used is not particularly limited, and is in the range of usually 0.01 to 100 moles, preferably 0.02 to 50 moles, more preferably 0.03 to 10 moles relative to 1 mole of the onium halide structural unit of the onium halide structural unit-containing polyether compound to be used.

The salt of the anion (X⁻) other than the halide ion and a metal cation used to perform the anion-exchange reaction is not particularly limited, and examples thereof include lithium bis(fluorosulfonyl)imide (Li(FSO₂)₂N), lithium bis (trifluoromethylsulfonyl) imide (Li(CF₃SO₂)₂N), lithium bis(pentafluoroethylsulfonyl)imide (Li(CF₃CF₂SO₂)₂N), sodium acetate (CH₃COONa), silver acetate (CH₃COOAg), lithium butyrate (C₃H₇COOLi), lithium trifluoroacetate (CF₃COOLi), lithium benzoate (PhCOOLi), potassium tetracyanoborate (KB(CN)₄), lithium thiocyanate (LiSCN), lithium bis(cyano)imide (Li(CN)₂N), lithium methylsulfonate (LiCH₃SO₃), lithium trifluoromethyl sulfonate (LiCF₃SO₃), potassium hydroxide (KOH), lithium perchlorate (LiClO₄), and the like. In the case of salts of a polyvalent anion and a metal cation, examples thereof include silver sulfate (Ag₂SO₄²⁻) and sodium carbonate (Na₂CO₃²⁻). Examples of salts of a polyanion having two or more monovalent anionic groups in the molecule and a metal cation include LiO₃SCF₂CF₂CF₂SO₃Li, LiO₃SCF₂CF₂SO₃Li, and

Li₂(CF₃SO₂NSO₂CF₂CF₂OCF₂CF₂OCF₂CF₂SO₂NSO₂CF₃).

The pressure when the anion-exchange reaction is performed is usually 1 to 500 atm, preferably 1 to 100 atm, particularly preferably 1 to 50 atm. The temperature during the reaction is usually -30 to 200°C, preferably -15 to 180°C, more preferably 0 to 150°C. The reaction time is usually 1 minute to 1000 hours, preferably 3 minutes to 100 hours, more preferably 5 minutes to 10 hours, still more preferably 5 minutes to 3 hours.

After the completion of the anion-exchange reaction, the metal cation, the halide ion, and the salts thereof, and the like can be removed by washing with water or the like or membrane separation with a membrane such as a semipermeable membrane to collect a mixture containing the cationic group-containing polyether (A). Alternatively, the cationic group-containing polyether (A) can be extracted using a solvent such as methanol to collect a mixture containing the cationic group-containing polyether (A). Further, the intended cationic group-containing polyether (A) can be collected in accordance with an ordinary method such as drying in vacuo, for example.

For the cationic group-containing polymer used in the present invention, examples of the polymer having a cationic group in the side chain of the polymer also include a side chain ammonium group-containing polymer (B) containing a repeating unit represented by General Formula (3) below: 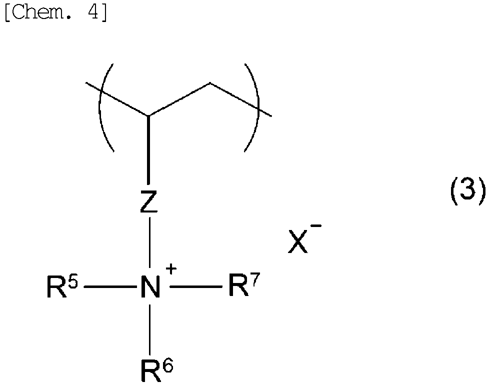 (where in General Formula (3) above, Z represents a divalent linking group, R⁵ to R⁷ each independently represent a hydrogen atom or a substituent, and R⁵ to R⁷ may be bonded to each other; in General Formula (3), X⁻ represents an anion).

Z is a divalent linking group, and is preferably an alkylene group optionally containing a heteroatom. Examples of the heteroatom include an oxygen atom, a nitrogen atom, a sulfur atom, and the like. Examples of a group containing a heteroatom include an amide group (-CO-NH-), an ester group (-COO-), an ether group (-O-), a thioether group (-S-), and the like. Among these, Z is preferably an alkylene group containing an amide group, more preferably a group represented by -CO-NH-(CH₂)ₚ- (where p is an integer of 1 to 5, preferably n = 3).

It is sufficient that R⁵ to R⁷ are each independently a hydrogen atom or a substituent, and R⁵ to R⁷ are not particularly limited. R⁵ to R⁷ are each independently preferably a hydrogen atom or a hydrocarbon group, more preferably a hydrogen atom, an alkyl group, or a vinyl group, still more preferably a hydrogen atom or an alkyl group, particularly preferably an alkyl group. R⁵ to R⁷ each independently have preferably 1 to 8 carbon atoms, more preferably 1 to 4 carbon atoms, still more preferably 1 to 3 carbon atoms, particularly preferably one carbon atom. That is, R⁵ to R⁷ are preferably a methyl group.

In General Formula (3) above, the anion represented by X⁻ is not particularly limited, and examples thereof include the same anions as those listed in General Formula (1).

The side chain ammonium group-containing polymer (B) may contain a repeating unit other than the repeating unit represented by General Formula (3). It is sufficient that the repeating unit other than the repeating unit represented by General Formula (3) is a unit derived from a monomer copolymerizable with the monomer which gives the repeating unit represented by General Formula (3). Examples thereof include, but are not particularly limited to, units derived from unsaturated carboxylic acids, such as acrylic acid and methacrylic acid, and salts thereof, unsaturated carboxylic acid esters, such as methyl acrylate, methyl methacrylate, ethyl acrylate, ethyl methacrylate, n-butyl acrylate, n-butyl methacrylate, and methoxyethoxyethoxyethyl acrylate, acrylamide, substituent-containing acrylamides, styrene, vinylpyridine, vinylpyrrolidone, and the like.

In the side chain ammonium group-containing polymer (B) used in the present invention, the units represented by General Formula (3) above are each independent, and two or more types of the units represented by General Formula (3) may be present in the side chain ammonium group-containing polymer (B). When the side chain ammonium group-containing polymer (B) used in the present invention contains two or more types of the repeating units, although a distribution pattern of those repeating units is not particularly limited, the repeating units preferably have a random distribution.

Specific examples of the side chain ammonium group-containing polymer (B) used in the present invention include poly{[3-(methacryloylamino)propyl]trimethylammonium chloride}, poly[(3-acrylamidepropyl)trimethylammonium chloride], poly{[2-(methacryloyloxy)ethyl]trimethylammonium chloride}, poly{[2-(acryloyloxy)ethyl]trimethylammonium chloride}, poly[2-dimethylaminoethyl methacrylate ethyl sulfuric acid salt], poly[vinylbenzyltrimethylammonium chloride], poly[N-(2-acryloyloxyethyl)-N-benzyl-N,N-dimethylammonium chloride], poly[2-methacryloyloxyethyl phosphorylcholine], poly[2-(N-3-sulfopropyl-N,N-dimethylammonium)ethyl methacrylate], and the like. Among these, preferred is poly[(3-acrylamidepropyl)trimethylammonium chloride].

The weight average molecular weight (Mw) of the side chain ammonium group-containing polymer (B) used in the present invention is preferably 750 to 2,000,000, more preferably 1,000 to 1,500,000, still more preferably 2,000 to 1,000,000, particularly preferably 4,000 to 500,000, although not particularly limited thereto. The weight average molecular weight of the side chain ammonium group-containing polymer (B) can be determined using GPC in terms of polystyrene.

For the cationic group-containing polymer used in the present invention, examples of the polymer having a cationic group in the side chain of the polymer also include a side chain cyclic ammonium group-containing polymer (C) containing a repeating unit represented by General Formula (4-1) or (4-2) below: 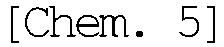 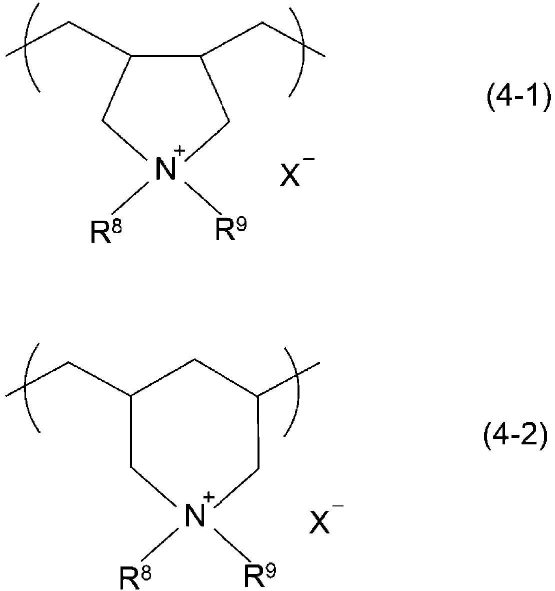 (where in General Formulae (4-1) and (4-2), R⁸ and R⁹ each independently represent a hydrogen atom or a substituent, and R⁸ and R⁹ may be bonded to each other; and in General Formulae (4-1) and (4-2), X⁻ represents an anion) .

It is sufficient that R⁸ and R⁹ are each independently a hydrogen atom or a substituent. Although R⁸ and R⁹ are not particularly limited, it is preferred that R⁸ and R⁹ be each independently a hydrogen atom or a hydrocarbon group, more preferred that R⁸ and R⁹ be each independently a hydrogen atom, an alkyl group, or a vinyl group, still more preferred that R⁸ and R⁹ be each independently a hydrogen atom or an alkyl group, and particularly preferred that R⁸ and R⁹ be each independently an alkyl group. R⁸ and R⁹ each independently have preferably 1 to 8 carbon atoms, more preferably 1 to 4 carbon atoms, still more preferably 1 to 3 carbon atoms, particularly preferably one carbon atom. That is, R⁸ and R⁹ are preferably a methyl group.

Examples of the anion represented by X⁻ in General Formulae (4-1) and (4-2) above include, but are not particularly limited to, the same anions as those listed in General Formula (1) above.

The side chain cyclic ammonium group-containing polymer (C) may contain a repeating unit other than the repeating units represented by General Formulae (4-1) and (4-2). It is sufficient that the repeating units other than the repeating units represented by General Formula (4) are units derived from monomers copolymerizable with monomers which give the repeating units represented by General Formulae (4-1) and (4-2) above, and they are not particularly limited. Examples of such monomers include N-vinylpyrrolidone, acrylamide, (meth)acrylic acid, (meth)acrylic acid salts, (meth)acrylates having an ethylene oxide unit, and the like.

In the side chain cyclic ammonium group-containing polymer (C) used in the present invention, the units represented by General Formula (4) above are each independent, and two or more types of the units represented by General Formula (4) may be present in the side chain cyclic ammonium group-containing polymer (C). When the side chain cyclic ammonium group-containing polymer (C) used in the present invention contains two or more types of the repeating units, although a distribution pattern of those repeating units is not particularly limited, the repeating units preferably have a random distribution.

Specific examples of the side chain cyclic ammonium group-containing polymer (C) used in the present invention suitably include poly(diallyldimethylammonium chloride), and the like.

The weight average molecular weight (Mw) of the side chain cyclic ammonium group-containing polymer (C) used in the present invention is preferably 750 to 2,000,000, more preferably 2,000 to 1,500,000, still more preferably 4,000 to 1,000,000, particularly preferably 10,000 to 500,000, although not particularly limited thereto. The weight average molecular weight of the side chain cyclic ammonium group-containing polymer (C) can be determined using GPC in terms of polystyrene.

Furthermore, for the cationic group-containing polymer used in the present invention, examples of the polymer having a cationic group in the main chain of the polymer include a main chain ammonium group-containing polymer (D) containing a repeating unit represented by General Formula (5): 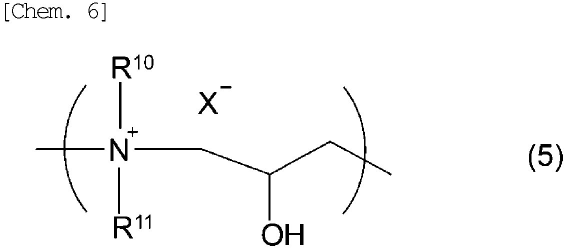 (where in General Formula (5) above, R¹⁰ and R¹¹ each independently represent a hydrogen atom or a substituent, and R¹⁰ and R¹¹ may be bonded to each other; and in General Formula (5), X⁻ represents an anion).

R¹⁰ and R¹¹ each independently represent a hydrogen atom or a substituent. Although R¹⁰ and R¹¹ are not particularly limited, it is preferred that R¹⁰ and R¹¹ be each independently a hydrogen atom or a hydrocarbon group, more preferred that R¹⁰ and R¹¹ be each independently a hydrogen atom, an alkyl group, or a vinyl group, still more preferred that R¹⁰ and R¹¹ be each independently a hydrogen atom or an alkyl group, and particularly preferred that R¹⁰ and R¹¹ be each independently an alkyl group. R¹⁰ and R¹¹ each independently have preferably 1 to 8 carbon atoms, more preferably 1 to 4 carbon atoms, still more preferably 1 to 3 carbon atoms, particularly preferably one carbon atom. That is, R¹⁰ and R¹¹ are preferably a methyl group.

In General Formula (5) above, examples of the anion represented by X⁻ include, but are not particularly limited to, the same anions as those listed in General Formula (1) above.

The main chain ammonium group-containing polymer (D) can be obtained by reacting a secondary amine and epihalohydrin for forming the repeating unit represented by General Formula (5).

The secondary amine is a compound with one nitrogen atom bonded to two hydrocarbon groups and one hydrogen and a compound having a nitrogen atom in a hetero ring, the nitrogen atom having one hydrogen. Examples of such a secondary amine include aliphatic secondary amines, aromatic secondary amines, alicyclic secondary amines, heterocyclic secondary amines, and the like. These may be used in combination.

Examples of aliphatic secondary amines include dimethylamine, diethylamine, diisopropylamine, dibutylamine, methylethylamine, methylpropylamine, methylbutylamine, methyloctylamine, methyllaurylamine, dibenzylamine, and the like.

Examples of aromatic secondary amines include N-alkylanilines such as N-methylaniline, N-ethylaniline, N-propylaniline, N-butylaniline, N-pentylaniline, N-hexylaniline, N-octylaniline, N-decylaniline, N-laurylaniline, and N-benzylaniline; N-alkyltoluidines such as N-methyltoluidine, N-ethyltoluidine, N-propyltoluidine, N-butyltoluidine, N-pentyltoluidine, N-hexyltoluidine, N-octyltoluidine, N-decyltoluidine, N-lauryltoluidine, and N-benzyltoluidine; N-alkylnaphthylamines such as N-methylnaphthylamine, N-ethylnaphthylamine, N-propylnaphthylamine, N-butylnaphthylamine, N-pentylnaphthylamine, N-hexylnaphthylamine, N-octylnaphthylamine, N-decylnaphthylamine, N-laurylnaphthylamine, and N-benzylnaphthylamine; and the like.

Examples of alicyclic secondary amines include N-alkylcyclohexylamines such as N-methylcyclohexylamine, N-ethylcyclohexylamine, N-propylcyclohexylamine, N-butylcyclohexylamine, N-hexylcyclohexylamine, N-octylcyclohexylamine, N-decylcyclohexylamine, and N-laurylcyclohexylamine; N-alkylcyclooctylamines such as N-methylcyclooctylamine, N-ethylcyclooctylamine, N-propylcyclooctylamine, N-butylcyclooctylamine, N-hexylcyclooctylamine, N-octylcyclooctylamine, N-decylcyclooctylamine, and N-laurylcyclooctylamine; dicycloalkylamines such as dicyclohexylamine and dicyclooctylamine; and the like.

Examples of heterocyclic secondary amines include piperidine, pyrrolidine, 2-methylpiperidine, 4-methylpiperidine, and the like.

As the secondary amine, preferred are aliphatic secondary amines, preferred are dimethylamine and diethylamine, and particularly preferred is dimethylamine.

Examples of epihalohydrin include epichlorohydrin, epibromohydrin, methylepichlorohydrin, methylepibromohydrin, and the like. Among these, epichlorohydrin is particularly preferred.

The main chain ammonium group-containing polymer (D) may be obtained by reacting an amine other than the secondary amine with the secondary amine and epihalohydrin. Examples of the amine other than the secondary amine include compounds having two or more amino groups, such as ethylenediamine, propylenediamine, diethylenetriamine, hexylenediamine, triethylenetetramine, tetraethylenepentaamine, isophoronediamine, piperazine, diphenylmethanediamine, hydrazine, and hydrazides such as adipic dihydrazide. Among these, ethylenediamine is suitably used.

The main chain ammonium group-containing polymer (D) is prepared, for example, by mixing the secondary amine, the epihalohydrin, and the amine other than the secondary amine optionally used with stirring under a heating condition, and addition polymerizing these by a known conventional method.

The weight average molecular weight (Mw) of the main chain ammonium group-containing polymer (D) used in the present invention is preferably 750 to 2,000,000, more preferably 2,000 to 1,500,000, still more preferably, 4,000 to 1,000,000, particularly preferably 10,000 to 500,000, although not particularly limited thereto. The weight average molecular weight of the main chain ammonium group-containing polymer (D) can be determined using GPC in terms of polystyrene.

The radio wave shielding body according to the present invention contains the cationic group-containing polymer such as the cationic group-containing polyether (A), the side chain ammonium group-containing polymer (B), the side chain cyclic ammonium group-containing polymer (C), and the main chain ammonium group-containing polymer (D) described above. As described above, the cationic group-containing polymer is not limited to these polymers, and can be any polymer having a cationic group in the polymer chain, and is not particularly limited.

The radio wave shielding body according to the present invention may be a cross-linked product (three-dimensionally cross-linked product) obtained by cross-linking (three-dimensional cross-linking) the cationic group-containing polymer, or may be a cross-linked product (three-dimensionally cross-linked product) obtained by causing the cationic group-containing polymer to coexist with another cross-linkable polymer capable of forming a cross-linked structure, and cross-linking (three-dimensional cross-linking) such cross-linkable polymers. Examples of cross-linking methods include methods such as ultraviolet light irradiation, visible light irradiation, heating, electron beam irradiation, radiation irradiation, and the like. A urethane reaction, an epoxy reaction, a reaction of an oxazoline group, a dimerized reaction of cinnamic acid or the like, a reaction of an azetidinium ring, or the like can also be used.

In the radio wave shielding body according to the present invention, the cationic group-containing polymer itself has radio wave shielding performance. The proportion of the cationic group-containing polymer in the radio wave shielding body according to the present invention is not particularly limited, and can be appropriately selected according to the application, the purpose, and the like. The radio wave shielding body according to the present invention contains the cationic group-containing polymer in a proportion of preferably 1 to 100% by weight, preferably 3 to 100% by weight, more preferably 5 to 100% by weight, still more preferably 10 to 100% by weight, further still more preferably 30 to 100% by weight, particularly preferably 50 to 100% by weight. If the content of the cationic group-containing polymer is too small, sufficient radio wave shielding performance cannot be obtained in some cases. For example, the cationic group-containing polymer may also be used as a wet strengthening agent in a sedimentation treatment for sludge or in the paper making industry. The cationic group-containing polymer in sludge is about less than 1%, and the cationic group-containing polymer contained in paper is about 0.1%. In both cases, the content thereof is very small, and the radio wave shielding performance cannot be sufficiently demonstrated.

The radio wave shielding body according to the present invention may be a composition containing the cationic group-containing polymer and water. A composition having such a configuration can provide high adhesiveness. The content of the cationic group-containing polymer in this case is preferably 55% by weight or more, more preferably 60% by weight or more, still more preferably 65% by weight or more from the viewpoint of self-supporting strength, and is preferably less than 100% by weight, more preferably 95% by weight or less, still more preferably 90% by weight or less from the viewpoint of the adhesiveness. The content of the water is preferably more than 1% by weight, more preferably 5% by weight or more, still more preferably 10% by weight or more, and is preferably 45% by weight or less, more preferably 40% by weight or less, still more preferably 35% by weight or less.

In the radio wave shielding body according to the present invention, the ions in the cationic group-containing polymer are preferably dissociated. When the ions are dissociated, high flexibility can be obtained, thereby facilitating processing and reducing breakage. Dissociation of the ions can be determined according to the ion conductivity by an AC impedance method. When the ion conductivity is observed in order of about 10⁻¹⁰ to 10⁻⁹ S/cm, it can be determined that the ions are dissociated. When the ions are insufficiently dissociated, dissociation of the ions may be promoted by adding a solvent. Examples of the solvent include water, organic solvents, oils, ionic liquids, and the like. Preferred organic solvents are alcohols, particularly polyhydric alcohols, and preferred oils are modified silicone oils, particularly silicone oils modified with an ethylene oxide chain from the viewpoint of compatibility.

The shape of the radio wave shielding body according to the present invention is not particularly limited, and for example, a sheet- or plate-like shape is preferred. In this case, the radio wave shielding body in a sheet- or plate-like shape can be used as a monolayer, or multiple layers thereof laminated can be used. When multiple layers of the radio wave shielding body are laminated and used, the number of reflections can be increased, and thereby the radio wave shielding performance can be adjusted. When multiple layers are laminated, the radio wave shielding bodies according to the present invention may be laminated, or a sheet or plate different from the radio wave shielding body according to the present invention may be sandwiched between a pair/pairs of the radio wave shielding bodies according to the present invention. The radio wave shielding material may be a graded material whose composition gradually changes. The radio wave shielding body according to the present invention can also be used as a bulk body (= bulk). It may be formed into any shape as in clay molding, or may be used to fill in gaps as putty. Furthermore, the radio wave shielding body according to the present invention may be a foam.

For example, when the radio wave shielding body according to the present invention in a sheet- or plate-like shape is formed, the forming method is not particularly limited. When the cationic group-containing polymer contained in the radio wave shielding body according to the present invention is liquid at ambient temperature, the cationic group-containing polymer may be held by a sheet- or plate-like support to give a sheet- or plate-like shape. Examples of such a forming method include a method of sandwiching the cationic group-containing polymer by a pair of supports.

Alternatively, when the radio wave shielding body according to the present invention in a sheet- or plate-like shape or as a bulk body is formed, the radio wave shielding body in a sheet- or plate-like shape or as a bulk body may be formed by injecting the radio wave shielding body in a state of a monomer having fluidity into a desired site, followed by polymerization in situ. When the radio wave shielding body according to the present invention is produced as a cross-linked product obtained by cross-linking the cationic group-containing polymer or produced as a cross-linked product obtained by causing a cross-linkable polymer capable of forming a cross-linked structure to coexist and cross-linking the polymers, the radio wave shielding body in a sheet- or plate-like shape or as a bulk body may be formed by injecting the radio wave shielding body in a state of a monomer or polymer having fluidity into a desired site, followed by polymerization in situ.

When the radio wave shielding body according to the present invention in a sheet- or plate-like shape is formed, the surface of the sheet- or plate-like radio wave shielding body may be subjected to surface roughening or grooving on the surface for the purpose of scattering radio waves on the sheet or plate surface. In this case, where visible light is easy to scatter, to ensure the eyesight, a surface material along the roughened or grooved surface (e.g., a surface material composed of methyl methacrylate as the material) may be disposed to cover depressions and projections of the roughened or grooved surface of the radio wave shielding body according to the present invention, and the physical surface may be a smooth surface derived from the surface of the surface material.

The radio wave shielding body according to the present invention preferably has an exterior member. For example, when the radio wave shielding body according to the present invention is in a sheet- or plate-like shape, in a preferred mode, a pair of sheet- or plate-like exterior members are used as the exterior member, and the radio wave shielding body is sandwiched between the pair of exterior members. When the radio wave shielding body according to the present invention has the exterior member(s), reflection attenuation can be increased, and reflected radio waves can be reduced.

In the exterior member, an organic material such as plastics or rubber or an inorganic material such as glass or ceramics is preferably used. The exterior member preferably has a water-repellent outermost layer. Whether the exterior member is water-repellent can be determined by dropping water onto the surface of the exterior member and observing whether the water soaks into the inside of the exterior member. If whether the water soaks into the inside of the exterior member cannot be determined in the method of dropping water, the water-repellency can be determined by immersing the exterior member in water and determining whether the weight increase ratio is 1% by weight or less.

From the viewpoint of dimensional stability and low flammability, an inorganic material such as glass or ceramics is preferably used in the exterior member. From the viewpoint of difficulties in breaking the radio wave shielding body, an organic material is preferably used. In particular, from the viewpoint of freedom of the shape, a resin material is preferably used. From the viewpoint of freedom of the shape of the radio wave shielding body and freedom of deformation, a rubber material is preferably used. Among these resin materials, preferred are chlorinated resins such as vinyl chloride resin and chlorinated polyvinyl chloride, polyimide resins, fluorinated resins, and polycarbonate resins from the viewpoint of low flammability. Among these rubber materials, preferred are silicone rubbers, fluorocarbon rubbers, and urethane rubbers from the viewpoint of low flammability.

Damage of the surface of the radio wave shielding body may affect the radio wave absorption performance. Thus, the outermost layer of the exterior member preferably has a pencil hardness of H or higher, which makes it easier to maintain the radio wave absorption performance for a long time. The pencil hardness of the outermost layer of the exterior member is more preferably 2H or higher, still more preferably 3H or higher, further still more preferably 4H or higher. The amount of the covering by the exterior member is preferably 30% or more of the total radio wave shielding body, more preferably 40% or more, still more preferably 50% or more, and the upper limit is preferably 100% or less, more preferably 95% or less, still more preferably 90% or less.

Furthermore, the radio wave shielding body according to the present invention contains the cationic group-containing polymer and has flexibility. Thus, owing to the flexibility, the radio wave shielding body according to the present invention can be used in a variety of applications, and may be reinforced by a variety of methods when it is used.

Examples of a reinforcing method include a method of integrating the radio wave shielding body with a surface material such as a plastic plate, a plastic film, a hardcoat, a rubber plate, a rubber film, a glass plate, a glass film, or a metal foil. The surface material preferably has a hardness of pencil hardness B or higher. The radio wave shielding body according to the present invention may be reinforced by placing a frame material around the radio wave shielding body, and examples of a frame material include metals, wood materials, plastics, glass and the like.

Examples of the reinforcing method also include a method of integrating the radio wave shielding body in a sheet- or plate-like shape or as a bulk with a fibrous material, a method of mixing a fibrous material with the cationic group-containing polymer to prepare a radio wave shielding body, and the like. Examples of the fibrous material include glass fibers, natural fibers, synthetic fibers, carbon fibers, carbon nanotubes, ceramic fibers, PTFE, and the like, and millifibers, microfibers, nanofibers, and the like can be used without limitation. The fibrous material may be a monofilament, may be a twist yarn, may be a coiled form, may be a textile, or may be a non-woven fabric.

Further, examples of the reinforcing method include a method of mixing a filler with the cationic group-containing polymer to prepare a radio wave shielding body. Examples of the filler include particulate fillers, whisker, fibrous substances, conductive substances, magnetic substances, metals, carbon materials, ceramics, nanofibers, microfibers, dyes, pigments, foaming agents, hollow particles, and the like. The particle sizes of these are not particularly limited. In particular, when a radio wave shielding body maintaining transparency is prepared, a filler having transparency is preferably used, and it is desired that the refractive index of the cationic group-containing polymer is the same as that of the filler. Examples of the filler having transparency include resin powders, glass powders, and the like.

Examples of the reinforcing method also include a method of mixing the cationic group-containing polymer and a different polymer to prepare a radio wave shielding body. Examples of the different polymer include a variety of neutral polymers, a variety of anionic polymers, and the like. As described above, a cross-linkable polymer capable of forming a cross-linked structure can be caused to coexist.

The radio wave shielding body according to the present invention in a sheet- or plate-like shape has a thickness of preferably 10 µm to 3 cm, more preferably 50 µm to 2 cm, still more preferably 100 µm to 1.5 cm. When the radio wave shielding body according to the present invention in a sheet- or plate-like shape is formed, to sufficiently enhance the radio wave shielding performance, the basis weight of the cationic group-containing polymer in the thickest portion is preferably 100 µg/cm² or more, more preferably 500 µg/cm² or more, still more preferably 1000 µg/cm² or more. The upper limit thereof is preferably 5 g/cm² or less, although not particularly limited.

From the viewpoint of flexibility, the radio wave shielding body according to the present invention has a Duro-A hardness of preferably HDA 60 or lower, more preferably HDA 55 or lower, still more preferably HDA 50 or lower, further still more preferably HDA 45 or lower. When the Duro-A hardness falls within the above ranges, air bubbles are likely to disappear even if air bubbles are contained in the bonding interface when the radio wave shielding body is bonded to a member bonded.

Although the radio wave shielding body according to the present invention contains a cationic group-containing polymer and the cationic group-containing polymer itself has high radio wave shielding performance, the radio wave shielding body according to the present invention may contain an additional radio wave absorption material to further improve the radio wave shielding performance or adjust the radio wave shielding performance. Examples of the additional radio wave absorption material include carbon materials such as graphite, metals, conductive polymers, conductive ceramics, magnetic substances, and the like.

Furthermore, the radio wave shielding body according to the present invention may include a conductive layer. The conductive layer can be formed from ITO, PEDOT, copper, silver, gold, or the like, for example. The conductive layer may be disposed across the radio wave shielding body, or may be intermittently disposed. Examples of the latter include a stripe pattern, a mesh pattern, a repeated pattern, and the like. Using the conductive layer, a λ/4 structure may be implemented. By appropriately drawing the pattern of the conductive layer, reflection and refraction amounts of the electromagnetic wave and the angles thereof can also be controlled.

The radio wave shielding body according to the present invention in a sheet- or plate-like shape can be used in the forms such as a partition, a divider, a wall material (wall, wall paper), a humidity conditioner, a water collecting material, a water dissipating material, a thermal barrier, a curtain, a window, an apron, a hat/cap, eyeglasses, a cloth, and a coat.

When the radio wave shielding body according to the present invention is used as a humidity conditioner, an exterior member having air permeability is preferably used as the above-mentioned exterior member, and the exterior member is preferably a non-woven fabric or a porous membrane. Examples of materials therefor include plastics, paper, metals, ceramics, and the like. From the viewpoint of preventing water penetration while letting water vapors to pass through, the non-woven fabric or the porous membrane preferably has a small pore diameter. The pore diameter is preferably 100 µm or less, more preferably 50 µm or less, still more preferably 10 µm or less. From the viewpoint of water repellency, a fluorine-based polymer or a hydrocarbon-based polymer is suitable.

When the radio wave shielding body according to the present invention is used as a curtain, an exterior member having high flexibility and low flammability is preferably used as the above-mentioned exterior member. Specifically, examples of materials therefore include vinyl chloride resin, vinylidene chloride resin, chlorinated polyvinyl chloride, silicone rubber, urethane, polycarbonate, and the like.

Alternatively, when the radio wave shielding body according to the present invention as a bulk body (= bulk) is formed, for example, it can be placed in a room as a stationary article to absorb radio waves, or it can absorb unnecessary radio waves by placing it near an electrical circuit product, using it as a housing for an electrical circuit product, or placing it in a predetermined space in the casing of an electronic device. The radio wave shielding body according to the present invention can also be used as a sealing material for a variety of electrical and electronic parts.

Furthermore, the radio wave shielding body according to the present invention may be used in a state where another radio wave reflector is disposed on an outer side of the radio wave shielding body. This can increase freedom in design of reflection and absorption. Specific examples of another radio wave reflector include metal plates, carbon-containing plates, metal meshes, glass and plastics including a conductive layer, and the like. In this case, the angle of the radio wave shielding body according to the present invention and that of another radio wave reflector are configured to be variable by hand or automatically, which can further increase freedom in design of reflection and absorption. Furthermore, the radio wave shielding body according to the present invention, which has high stretchability and flexibility, can be bent by hand or automatically in a desired curvature for use.

The adhesive composition according to the present invention is an adhesive composition comprising a cationic group-containing polymer having a cationic group in the polymer chain, and water,
wherein the content of the cationic group-containing polymer in the adhesive composition is 55% by weight or more and 95% by weight or less, and the content of the water in the adhesive composition is 5% by weight or more and 45% by weight or less.

Since the adhesive composition according to the present invention comprises a cationic group-containing polymer having a cationic group in the polymer chain and water in the above-mentioned specific ranges, it can demonstrate high adhesiveness and strength and allow easy removal after it is used.

Here, as tackiness agents and adhesives, acrylic tackiness agents, SIS-based tackiness agents, polyvinyl butyral, and the like are well known. However, while these, when used, tightly bond pieces and sufficiently serve the function, disassembly after use is difficult or needs a large number of steps. For this reason, there has been a demand for an adhesive which implements sufficient bonding strength and allows easy separation after it is used. In contrast, the adhesive composition according to the present invention can implement high adhesiveness and strength and further allow easy removal after it is used, and more specifically, it can allow easy removal by using water.

In particular, a composite material such as laminated glass is difficult to dissemble into original members, leading to difficulties in recycling. To this, when the tackiness agents and adhesives such as an acrylic tackiness agent, an SIS-based tackiness agent, and polyvinyl butyral are removed by a physical force, a substrate is broken or the tackiness agent is left, and perfect removal is difficult. It can be considered that the acrylic tackiness agent is removed by a method of using an organic solvent. However, it is not preferred from the viewpoint of the working environment because it is flammable and has bad influences over human bodies. Furthermore, an organic solvent or hydrofluoric acid is used to remove polyvinyl butyral used in laminated glass for automobiles, and these are not preferred as described above. In particular, when the substrate as the composite object is an organic material such as plastics, it is also considered that the substrate is damaged through a removal operation using an organic solvent. In contrast, the adhesive composition according to the present invention can implement high adhesiveness and strength, and further allows easy removal after it is used. Thus, it can effectively solve the above-mentioned problems, and can be suitably used in the above-mentioned application. In a preferred mode, the adhesive composition according to the present invention is used in combination with a polyvinyl butyral layer.

In addition, there is another problem that while the above-mentioned tackiness agent or adhesive such as polyvinyl butyral can increase the bonding strength of the material as the substrate, the above-mentioned tackiness agent or adhesive no longer bond pieces once peeling occurs for some reason. In contrast, the adhesive composition according to the present invention shows sufficient bonding strength when it is used, and allows re-bonding by contacting pieces even after unintentional peeling occurs. Thus, the adhesive composition according to the present invention is advantageous in that bonding is difficult to lose in applications where deformation or vibration repeatedly occurs.

Since the adhesive composition according to the present invention contains a cationic group-containing polymer having a cationic group in the polymer chain and thus has excellent radio wave absorbing properties, the adhesive composition can also be easily removed in a short time by a method other than the method of using water, such as a method of performing irradiation with a microwave (2.45 GHz) from an microwave oven to generate water vapors at a high temperature, thereby forcing open the interface. The adhesive composition according to the present invention can also be suitably used as a seal to be bonded to objects which are easy to damage by a peeling force, such as a cloth or furniture, and allows removal without damaging a cloth or furniture, by wetting the adhesive composition with water to cause spontaneous peeling, but not by mechanical peeling. In this case, a waterproof layer is preferably disposed in end portions when the cloth or furniture is used before removal.

The adhesive removable with water includes a typical glue formed from a natural water-soluble polymer, for example. However, such a glue formed from a natural water-soluble polymer is solidified during bonding, and thereby implements adhesiveness. Thus, the glue does not have stretchability or flexibility, and causes peel-off when it receives mechanical strain. In addition to this problem, the peeled pieces can be bonded again by wetting these with water, but successful bonding is difficult. Although the natural water-soluble polymer can be swelled for a long time, this causes molds and germs in the naturally derived polymer and leads to a bad appearance. Furthermore, decomposition of the water-soluble polymer itself proceeds.

The cationic group-containing polymer having a cationic group in the polymer chain which is contained in the adhesive composition according to the present invention can be any polymer having a cationic group in the polymer chain without limitation. It may be a polymer having a cationic group in the main chain of the polymer, may be a polymer having a cationic group in the side chain of the polymer, or may be a polymer having a cationic group in the main chain and side chain of the polymer. According to the present invention, high adhesiveness can be implemented by the cationic group in the cationic group-containing polymer. As such a cationic group-containing polymer, the same cationic group-containing polymers as those listed in the radio wave shielding body can be used as in the above-mentioned modes.

From the viewpoint of shape retention during bonding, preferably, the adhesive composition according to the present invention is a curable composition which is prepared by using a cationic group-containing polymer curable by polymerization and/or cross-linking. Examples of a polymerization and/or cross-linking method include methods such as ultraviolet light irradiation, visible light irradiation, heating, electron beam irradiation, and radiation irradiation. A urethane reaction, an epoxy reaction, a reaction of an oxazoline group, a dimerization reaction of cinnamic acid or the like, a reaction of an azetidinium ring, or the like can also be used. The adhesive composition according to the present invention can be formed into a gel by polymerization and/or cross-linking, thereby obtaining a molded body obtained by forming a gel of the adhesive composition according to the present invention. The shape of the molded body is not particularly limited as long as the shape is suitable for bonding. For example, the molded body can be a sheet-like molded body or a layered molded body. Alternatively, when the adhesive composition curable by polymerization and/or cross-linking is formed into a gel, besides a method of polymerizing and/or cross-linking the cationic group-containing polymer itself, a method of adding another polymer or a polyfunctional monomer, and then performing polymerization and/or cross-linking may be used.

In the molded body obtained using the adhesive composition according to the present invention, the Duro-A hardness is preferably HDA 50 or lower, more preferably HDA 45 or lower, still more preferably HDA 40 or lower, further still more preferably HDA 35 or lower from the viewpoint of flexibility and adhesiveness. When the Duro-A hardness falls within the above ranges, air bubbles are likely to disappear even if air bubbles are contained in the bonding interface when an adherent material is bonded.

Alternatively, when the adhesive composition according to the present invention is not polymerized or cross-linked, to ensure sufficient shape retention, use of a cationic group-containing polymer having a weight average molecular weight of 100,000 or more is preferred. The weight average molecular weight is more preferably 200,000 or more, still more preferably 300,000 or more.

The content of the cationic group-containing polymer in the adhesive composition according to the present invention is 55% by weight or more and 95% by weight or less, preferably 60% by weight or more and 90% by weight or less, more preferably 65% by weight or more and 85% by weight or less. The content of the water in the adhesive composition according to the present invention is 5% by weight or more and 45% by weight or less, preferably 10% by weight or more and 40% by weight or less, more preferably 15% by weight or more and 35% by weight or less. An excessively small content of the cationic group-containing polymer results in insufficient strength, and an excessively small content of water results in insufficient adhesiveness. Although it is sufficient that the content of the cationic group-containing polymer and that of water are within the above ranges in a usage environment, it is desired that these contents are within the above ranges at least under an environment at 25°C and 50%RH. Desirably, in consideration of its moisture absorbing properties, the content of the cationic group-containing polymer and that of water are measured after the adhesive composition is left for a long time (for example, about 1 week) to stabilize the adhesive composition.

The adhesive composition according to the present invention may also contain a component other than the cationic group-containing polymer and water, and may contain a salt such as sodium chloride or potassium chloride. When the adhesive composition according to the present invention contains a salt, ionic conductivity can be improved and corrosion resistance can be improved. Further, the adhesive composition according to the present invention may contain a surfactant, an anionic polymer, an amphoteric polymer, and the like. Further, the adhesive composition according to the present invention may have a pH adjusted by a method of adjusting the type of monomers used or a method of using a buffer.

Furthermore, the adhesive composition according to the present invention may be reinforced using a fibrous material. Examples of the fibrous material include glass fibers, natural fibers, synthetic fibers, carbon fibers, carbon nanotubes, ceramics fibers, PTFE, and the like, and millifibers, microfibers, nanofibers, and the like can be used without limitation. The fibrous material may be a monofilament, may be a twist yarn, may be a coiled form, may be a textile, or may be a non-woven fabric.

The adhesive composition according to the present invention can be suitably used as an adhesive. At this time, the adhesive composition according to the present invention may be formed into a gel to form a molded body, which may be used as an adhesive. The adhesive including such an adhesive composition according to the present invention can be suitably used as an adhesive for composite materials obtained by bonding a variety of materials to each other. For example, a composite material may be obtained by forming a composite of a first material and a second material bonded to each other by performing polymerization and/or cross-linking in a state where the adhesive composition according to the present invention is in contact with the first material and the second material. Alternatively, a composite material may be obtained by forming a composite of a first material and a second material by preliminarily forming a gel of the adhesive composition according to the present invention to form a sheet-like or layered molded body, and then bonding the first material and the second material with the molded body interposed therebetween. When the composite material is obtained, surfaces having a continuous area of 0.2 cm² or more can be bonded to each other. When a composite is obtained by bonding, the adhesive composition may be applied across the surfaces, or may be applied as spots.

The adhesive composition and the molded body according to the present invention, after these are used, allows easy removal from a composite material after use by using water. To further facilitate such removal and improve the removal rate, preferably, the adhesive composition and the molded body according to the present invention are capable of absorbing water in a weight five times or more the weight of the cationic group-containing polymer, thereby making the cationic group-containing polymer swellable or soluble in water. In the adhesive composition and the molded body according to the present invention, the amount of water to be absorbed is a weight more preferably 10 times or more, still more preferably 15 times or more, further still more preferably 20 times or more the weight of the cationic group-containing polymer. The upper limit is usually 200 times or less the weight of the cationic group-containing polymer, although not particularly limited.

In a preferred mode, by dissolving or swelling the adhesive composition and the molded body according to the present invention, the material included in the composite material is peeled off, thereby dissembling the composite material. In this case, after the disassembly, the cationic group-containing polymer is sedimented or dehydrated due to action of an anionic substance (such as a fatty acid soap). This can further reduce loads over wastewater disposal or thermal disposal.

Utilizing their properties, the adhesive composition and the molded body according to the present invention can be suitably used as adhesives used in radio wave shielding bodies, curtains, humidity conditioners, water collecting materials, water dissipating materials, thermal barriers, seals, patches, cushion materials, vibration insulators, flameproof and flame-retarding materials, and the like, for example.

### EXAMPLES

Hereinafter, the present invention will be more specifically described by way of Examples and Comparative Examples, but the present invention will not be limited only to these Examples. To be noted, the term "parts" is mass-based unless otherwise specified.

Test methods performed in Examples and Comparative Examples are shown below.

### <Weight average molecular weight (Mw) and molecular weight distribution (Mw/Mn)>

### (1) Weight average molecular weight (Mw) and molecular weight distribution (Mw/Mn) of base polymer

The weight average molecular weight (Mw) and molecular weight distribution (Mw/Mn) of the base polymer obtained in Example 1 were determined in terms of polystyrene by gel permeation chromatography (GPC) using tetrahydrofuran as a solvent. The measuring instrument used was HLC-8320 (available from Tosoh Corporation), the columns used were four TSKgel Super Multipore HZH (available from Tosoh Corporation) columns connected in series, and the detector used was a differential refractometer RI-8320 (available from Tosoh Corporation).

### (2) Weight average molecular weight (Mw) of imidazolium structure-containing polyether compound

For the imidazolium structure-containing polyether compounds obtained in Examples 1 and 2, the weight average molecular weight (Mw) was determined as follows. Specifically, first, the average molecular weight of all the repeating units constituting in the imidazolium structure-containing polyether compound was determined from the average molecular weight of the repeating units of the base polymer, the average molecular weight of various monomer units constituting in the polyether compound, and the contents of the various monomer units determined from (3) below. Then, the value obtained by multiplying the number of repeating units of the base polymer by the average molecular weight of all of the repeating units constituting the imidazolium structure-containing polyether compound was defined as the number average molecular weight (Mw) of the polyether compound.

### (3) Structure of base polymer, that of imidazolium structure-containing polyether compound, and contents of monomer units in base polymer and imidazolium structure-containing polyether compound

The structure of the base polymer, that of the imidazolium structure-containing polyether compound, and the contents of the monomer units in the base polymer and in the imidazolium structure-containing polyether compound were measured using a nuclear magnetic resonator (NMR) as follows. Specifically, first, 30 mg of a sample of the base polymer or the imidazolium structure-containing polyether compound was added to 1.0 mL of deuterochloroform or deuterated dimethyl sulfoxide, and was homogeneously dissolved by shaking for 1 hour. Then, the resulting solution was subjected to NMR measurement to obtain a ¹H-NMR spectrum, and the structure of the sample was determined in accordance with an ordinary method.

The content of the repeating unit represented by General Formula (2) in the imidazolium structure-containing polyether compound containing the repeating units represented by General Formula (2) was calculated by the following method. Specifically, first, the number of moles B1 of all the oxirane monomer units was calculated from an integrated value of protons derived from the oxirane monomer units in the main chain. Next, the number of moles B2 of the repeating units represented by General Formula (2) was calculated from an integrated value of protons derived from the imidazolium structure in the repeating units represented by General Formula (2). Then, the ratio (percentage) of B2 to B1 was determined as the content of the repeating units represented by General Formula (2) in the imidazolium structure-containing polyether compound.

### <Radio wave shielding performance to radio waves in gigahertz range>

For the radio wave shielding bodies (radio wave absorption material layers) obtained in Examples and Comparative Examples, each radio wave shielding body with a thickness of 3 mm was sandwiched between two acrylic plates having a length of 17 cm, a width of 17 cm, and a thickness of 2 mm, and the resulting laminate was used as a test sample. When the radio wave shielding body was a liquid or a solution, an acrylic plate having a thickness of 7 mm was further bonded to the outer peripheries of the two acrylic plates, thereby holding the liquid.

Using the test sample prepared above, the radio wave reflection attenuation amount (dB) and the transmission attenuation amount (dB) to the radio waves in a gigahertz range were measured in an environment at 23°C and 36 %RH. Specifically, the test sample prepared above was irradiated with radio waves in a direction vertical to the test sample by a free space method to measure S (Scattering) parameters (S11) and (S21) of a reflected wave and a transmitted wave. The frequency for measurement was in the range of 5.6 to 110 GHz. A larger reflection attenuation amount and transmission attenuation amount indicate higher absorption performance and higher blocking-off performance. The reflection attenuation amount is determined by the following formula. Furthermore, the reflection attenuation amount was converted into a reflectance.
reflection attenuation amount (dB) = 20log|S11|

The measurement conditions are shown below.

### (Configuration of apparatus)

· Free Space Microwave Measurement System (HVSFS, MAC SYSTEMS CORPORATION)
· Network analyzer: Keysight Technologies (Agilent Technologies, Inc.), N5227N, 10 MHz to 67 GHz
· Wave Guide T/R Module: Keysight Technologies (Agilent Technologies, Inc.), N5260-60004, 67 GHz to 110 GHz
· Millimeter-wave controller: Keysight Technologies (Agilent Technologies, Inc.), 8510XF
· Transmission/reception antenna (C-band): HVS Technologies FSS-01, with a dielectric lens
· Transmission/reception antenna (X-band): HVS Technologies FSS-04, with a dielectric lens
· Transmission/reception antenna (Ku-W-band): HVS Technologies FSS-07, with a dielectric lens
· Coaxial cable: Keysight Technologies (Agilent Technologies, Inc.), 11500-60002, 1 mm Test Cable

### (Measurement conditions)

· Focal length: 30.5 cm, based on the antenna-sample distance
· Plane of polarization: linearly polarized wave (Horizontal/Vertical)
· Frequency for measurement: 5.6 to 110 GHz

### <Radio wave shielding performance to radio waves in terahertz range>

Samples were prepared in the same manner as above except that an acrylic optical measurement cell was used instead of the acrylic plate, and were evaluated for transmittance of radio waves in a terahertz range (infrared region) using an ultraviolet-visible-near infrared spectrophotometer (available from JASCO Corporation, V-670). The range for measurement was 100 to 300 THz, and the measurement was performed with an optical path length of 10 mm.

### <Transmissivity of visible light>

Using all the test samples prepared in the test of radio wave shielding performance to radio waves in a gigahertz range, it was determined whether an object behind the sample was visually recognized. The test samples in Example 4 and Comparative Example 1 were also measured for transmittance of light in the visible light region. Specifically, in Example 4, the test sample was used after the acrylic layers (acrylic plates) were removed from the test sample, in Comparative Example 1, the test sample having a thickness of 3 mm was used, and was evaluated for transmittance of light in the visible light region using an ultraviolet-visible-near infrared spectrophotometer (available from JASCO Corporation, V-670). The range for measurement was 400 to 800 nm, and the measurement was performed.

### <Ion conductivity>

The radio wave shielding bodies obtained in Examples and Comparative Examples were measured for ion conductivity by an AC impedance method using an impedance analyzer (product name "Impedance Analyzer", available from Solartron), and were evaluated according to the criterion below.
A: The ion conductivity is 1.0 × 10⁻⁷ S/cm or higher.
B: The ion conductivity is less than 1.0 × 10⁻⁷ S/cm.

### <Example 1>

### (Living anionic polymerization of epichlorohydrin)

To a glass reactor equipped with a stirrer and purged with argon, 3.22 g of tetra-normal-butylammonium bromide and 30 ml of toluene were added, and this was cooled to 0°C. In the next step, 1.37 g of triethylaluminum dissolved in 10 ml of normal hexane was added, and the mixture was allowed to react for 15 minutes to obtain a catalyst composition. To the resulting catalyst composition, 10.0 g of epichlorohydrin was added, followed by polymerization reaction at 0°C. After the polymerization reaction was started, the viscosity of the solution gradually increased. After 12 hours of the reaction, a small amount of water was poured to the polymerization reaction solution to stop the reaction. The resulting polymerization reaction solution was washed with a 0.1 N hydrochloric acid aqueous solution to subject the catalyst residue to a deashing treatment. The residue was further washed with deionized water, and thereafter, an organic phase was dried in vacuo at 50°C for 12 hours. Thereby, a colorless transparent oily substance was obtained in a yield of 9.9 g. For the resulting substance, the weight average molecular weight (Mn) was 11,300 according to GPC, and the molecular weight distribution (Mw/Mn) was 1.13.

### (Quaternization of epichlorohydrin oligomer with 1-methylimidazole)

To a glass reactor equipped with a stirrer and purged with argon, 5.0 g of the epichlorohydrin oligomer obtained above, 12.1 g of 1-methylimidazole, and 10.0 g of acetonitrile were added, and were heated to 80°C. These materials were reacted at 80°C for 48 hours, and thereafter, were cooled to room temperature to stop the reaction. The resulting reaction product was washed with an equivalent-weight mixed solution of toluene/methanol/water, and then, an organic phase containing 1-methylimidazole and toluene was removed. The aqueous phase was dried in vacuo at 50°C for 12 hours, giving 9.4 g of a light red solid. From ¹H-NMR measurement and elemental analysis performed on the solid, the solid was identified as an imidazolium structure-containing polyether compound (cationic group-containing polyether composed of the repeating unit represented by Formula (6) below) having a halide ion as a counter anion in which all the chloro groups in the repeating units of the epichlorohydrin oligomer as a starting raw material were substituted by a 1-methylimidazolium group having a chloride ion as an counter anion and the bromo group in the bromomethyl group at the polymerization initiating ends was substituted by a 1-methylimidazolium group having a bromide ion as a counter anion. For the resulting imidazolium structure-containing polyether compound having a halide ion as a counter anion, the weight molecular weight (Mw) was 18,500 according to GPC, and the molecular weight distribution (Mw/Mn) was 1.13.

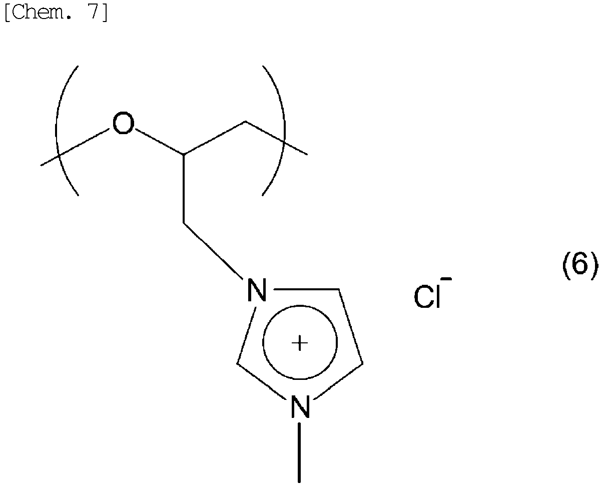

Then, water was added to the resulting imidazolium structure-containing polyether compound having a halide ion as a counter anion to adjust the solid concentration to 56% by weight, giving a viscous liquid radio wave shielding body. The resulting radio wave shielding body was measured for radio wave shielding performance to radio waves in a gigahertz range, that to radio waves in a terahertz range, transmissivity of visible light, and conductivity according to the above-mentioned methods. The results are shown in Tables 1 and 2.

### <Example 2>

### (Anion exchange of imidazolium structure-containing polyether compound having halide ion as counter anion with lithium bis(trifluoromethylsulfonyl)imide)

To a glass reactor with a stirrer, 2.5 g of the imidazolium structure-containing polyether compound having a halide ion as a counter anion obtained in Example 1, 4.1 g of lithium bis(trifluoromethylsulfonyl)imide, and 20 mL of deionized water were added. These materials were reacted at room temperature for 30 minutes, followed by drying in vacuo at 50°C for 12 hours. The resulting solid-liquid mixture was washed with water to remove inorganic salts, and then a liquid phase was extracted with toluene. The resulting toluene solution was dried in vacuo at 50°C for 12 hours, giving 5.7 g of a viscous liquid substance which was substantially colorless and transparent. From ¹H-NMR spectrum measurement and elemental analysis performed on the resulting viscosity liquid substance, this was identified as an imidazolium structure-containing polyether compound having a bis(trifluoromethylsulfonyl)imide anion as a counter anion (cationic group-containing polyether composed of a repeating unit represented by Formula (7) below), in which all the chloride ions and bromide ions in the imidazolium structure-containing polyether compound having a halide ion as a counter anion as a starting raw material were exchanged with a bis(trifluoromethylsulfonyl)imide anion. For the resulting imidazolium structure-containing polyether compound having a bis(trifluoromethylsulfonyl)imide anion as a counter anion, the weight molecular weight (Mw) according to GPC was 45,000, and the molecular weight distribution (Mw/Mn) was 1.13.

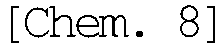

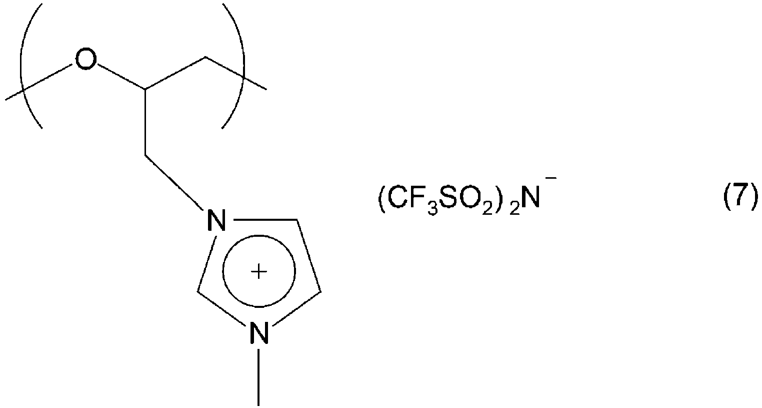

Then, the resulting imidazolium structure-containing polyether compound having a bis(trifluoromethylsulfonyl)imide anion as a counter anion was used as it was as a viscous liquid radio wave shielding body. The radio wave shielding body was measured for radio wave shielding performance to radio waves in a gigahertz range, that to radio waves in a terahertz range, transmissivity of visible light, and conductivity according to the above-mentioned methods. The results are shown in Tables 1 and 2.

### <Example 3>

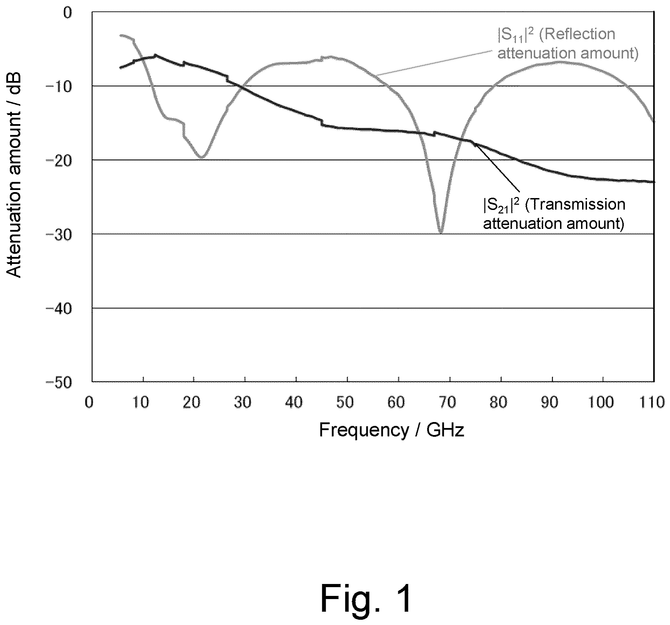

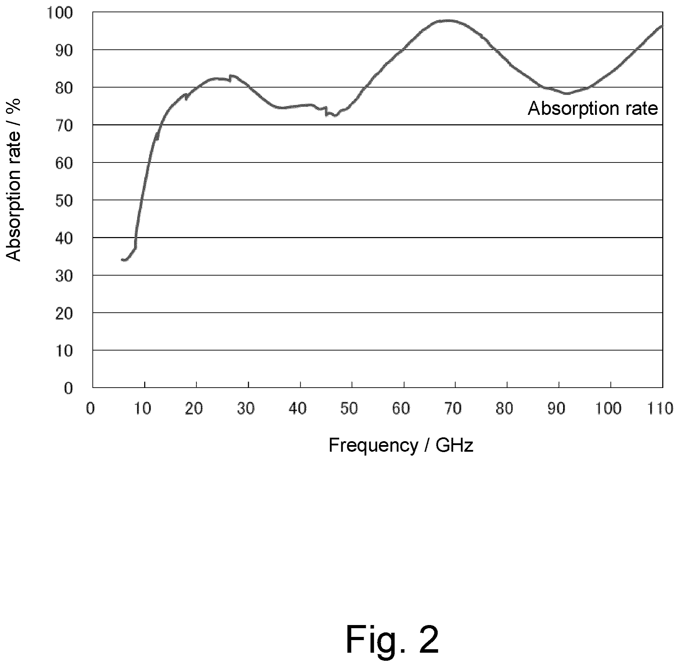

An aqueous solution of a dimethylamine-epichlorohydrin-ethylenediamine condensate composed of a repeating unit represented by Formula (8) below (available from Sigma-Aldrich Corporation, weight average molecular weight (Mw) = 250,000) was prepared, and the solid concentration was adjusted to 80% by weight, giving a viscous liquid radio wave shielding body. This was measured for radio wave shielding performance to radio waves in a gigahertz range, that to radio waves in a terahertz range, transmissivity of visible light, and conductivity according to the above-mentioned methods. The results are shown in Tables 1 and 2. Fig. 1 shows a graph of the reflection attenuation amount and the transmission attenuation amount in the gigahertz range in Example 3, and Fig. 2 shows a graph of the absorption rate in the gigahertz range. The graph of the absorption rate in Fig. 2 graphically shows the absorption rate of the radio wave shielding body in which the reflection attenuation amount and the transmission attenuation amount were considered.

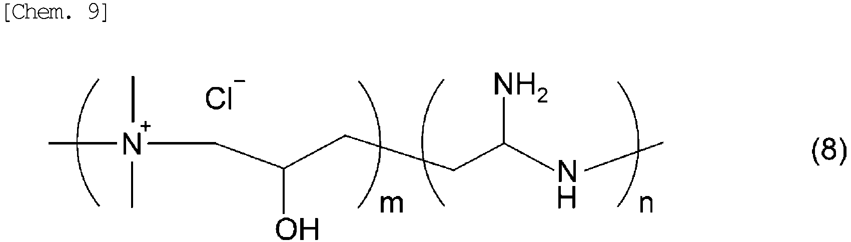

### <Example 4>

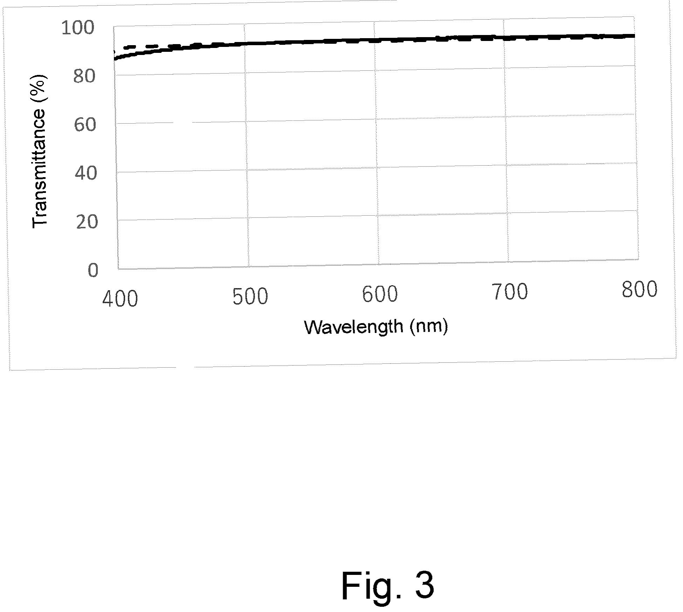

1 Part of methylenebismethacrylamide (available from Sigma-Aldrich Corporation) as a cross-linking agent and 1 part of 2-hydroxy-4'-(2-hydroxyethoxy)-2-methylpropiophenone (available from TOKYO CHEMICAL INDUSTRY CO., LTD.) as a photopolymerization initiator were added to 100 parts of a diallyldimethylammonium chloride solution (available from Sigma-Aldrich Corporation, 60% by weight aqueous solution), and were dissolved. Then, this solution was irradiated with UV light at 365 nm to cause polymerization and cross-linking, thereby giving a sheet-like radio wave shielding body (containing 40% by weight of water) containing a poly(diallyldimethylammonium chloride) cross-linked product composed of a repeating unit represented by Formula (9) below. The sheet was repeatedly stretchable and soft. This sheet was measured for radio wave shielding performance to radio waves in a gigahertz range, that to radio waves in a terahertz range, transmissivity of visible light, transmittance of visible light, and conductivity according to the above-mentioned methods. The results are shown in Tables 1 and 2. Fig. 3 shows a graph of the transmittance of visible light (the result in Example 4 is represented by the solid line).

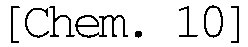

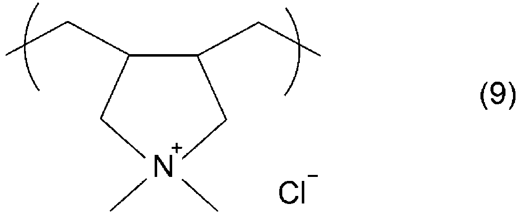

### <Example 5>

1 Part of methylenebisacrylamide (available from Sigma-Aldrich Corporation) as a cross-linking agent and 1 part of 1-[4-(2-hydroxyethoxy)-phenyl]-2-hydroxy-methyl propanone (available from TOKYO CHEMICAL INDUSTRY CO., LTD.) as a photopolymerization initiator were added to 100 parts of (3-acrylamidepropyl)trimethylammonium chloride solution (available from Sigma-Aldrich Corporation, 75% by weight aqueous solution), and were dissolved. Then, this solution was irradiated with UV light at 365 nm to cause polymerization and cross-linking, thereby giving a sheet-like radio wave shielding body (containing 25% by weight of water) containing a cross-linked product of the side chain ammonium group-containing polymer (B) composed of a repeating unit represented by Formula (10) below. The sheet was repeatedly stretchable and soft. Then, the resulting sheet-like radio wave shielding body was measured for radio wave shielding performance to radio waves in a gigahertz range, that to radio waves in a terahertz range, transmissivity of visible light, and conductivity according to the above-mentioned methods. The results are shown in Tables 1 and 2.

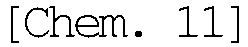

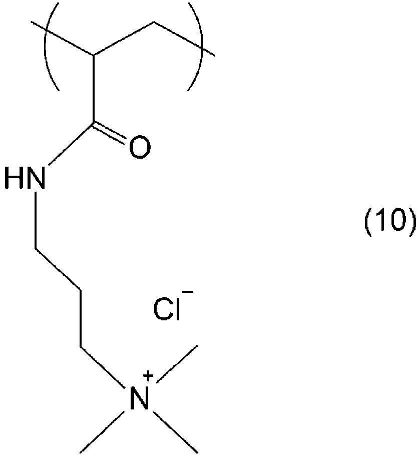

### <Comparative Example 1>

A 10-mm sheet of polymethyl methacrylate (available from Mitsubishi Chemical Corporation) was measured for radio wave shielding performance to radio waves in a gigahertz range, that to radio waves in a terahertz range, transmissivity of visible light, transmittance of visible light, and conductivity according to the above-mentioned methods. The results are shown in Tables 1 and 2. Fig. 3 shows a graph of the transmittance of visible light (the result in Comparative Example 1 is represented by the dashed line). A sample having a thickness of 3 mm was used in measurement of transmittance of visible light.

### [Table 1]

**Table 1**

| | Evaluation in gigahertz range | | | | | | | | | | | |
|---|---|---|---|---|---|---|---|---|---|---|---|---|
| | Reflectance (%) | | | | Transmission attenuation (dB) | | | | Absorption rate (%) | | | |
| | 30GHz | 45GHz | 80GHz | 110GHz | 30GHz | 45GHz | 80GHz | 110GHz | 30GHz | 45GHz | 80GHz | 110GHz |
| Ex. 1 | 16 | 30 | 13 | 5 | -29 | -37 | -47 | -54 | 82 | 70 | 84 | 95 |
| Ex. 2 | 3 | 20 | 5 | 3 | -3 | -4 | -7 | -10 | 41 | 48 | 72 | 85 |
| Ex. 3 | 11 | 22 | 12 | 3 | -10 | -14 | -19 | -23 | 80 | 72 | 87 | 96 |
| Ex. 4 | 9 | 21 | 8 | 5 | -14 | -18 | -23 | -28 | 87 | 77 | 91 | 94 |
| Ex. 5 | 4 | 16 | 8 | 6 | -5 | -8 | -10 | -12 | 65 | 68 | 82 | 89 |
| Comp. Ex. 1 | 10 | 1 | 10 | 1 | -1 | >-1 | -1 | -1 | 6 | 8 | 12 | 20 |

### [Table 2]

**Table 2**

| | Transmittance (%) in terahertz range | | Transparency (Transmissivity to visible light) | Ion conductivity |
|---|---|---|---|---|
| | 120THz | 210THz | | |
| | 2500nm | 1430nm | | |
| Ex. 1 | <1 | 5 | Transparent | A |
| Ex. 2 | <1 | 38 | Transparent | A |
| Ex. 3 | <1 | <1 | Transparent | A |
| Ex. 4 | <1 | 8 | Transparent | A |
| Ex. 5 | <1 | 2 | Transparent | A |
| Comp. Ex. 1 | <1 | 42 | Transparent | B |

As shown in Tables 1 and 2, in the radio wave shielding bodies containing a cationic group-containing polymer having a cationic group in the polymer chain, a large reflection attenuation amount or high reflectance, a large transmission attenuation amount, or a high absorption rate with respect to radio waves in a gigahertz range, low transmittance in a terahertz range, excellent radio wave shielding performance, high transmittance of visible light, and high transparency are verified (Examples 1 to 5). Moreover, the radio wave shielding bodies in Examples 1 to 5 had an ion conductivity of 1.0 × 10⁻⁷ S/cm or more, indicating that ions are sufficiently dissociated, and had high stretchability and flexibility, and thus were easy to process and difficult to break. Fig. 1 shows a graph of the reflection attenuation amount and the transmission attenuation amount in the gigahertz range in Example 3, Fig. 2 shows a graph of the absorption rate in consideration of the effects of reflection attenuation and transmission attenuation in Example 3,, and Fig. 3 shows a graph of the transmittance of visible light in Example 4 and Comparative Example 1.

### <Example 6>

1 Part of hexamethylene diisocyanate was mixed with 10 parts of an aqueous solution of a dimethylamine-epichlorohydrin-ethylene diamine condensate composed of the repeating unit represented by Formula (8) above (available from Sigma-Aldrich Corporation, weight average molecular weight (Mw) = 250,000), and the mixture was left to stand for 24 hours to proceed a cross-linking reaction. As a result of the reaction, the mixture no longer had fluidity, and a cross-linked product which was repeatedly stretchable and soft was obtained. The resulting cross-linked product was transparent, and was a product functioning as a radio wave shielding body as that in Example 3 and further also a product functioning as an ion conductor.

### <Example 7>

1 Part of ethylene glycol diglycidyl ether was mixed relative to 10 parts of an aqueous solution of a dimethylamine-epichlorohydrin-ethylene diamine condensate composed of the repeating unit represented by Formula (8) above (available from Sigma-Aldrich Corporation, weight average molecular weight (Mw) = 250,000), and the mixture was left to stand for 24 hours, thereby proceeding a cross-linking reaction. As a result of the reaction, the mixture no longer had fluidity, and a cross-linked product which was repeatedly stretchable and soft was obtained. The resulting cross-linked product was transparent, and was a product functioning as a radio wave shielding body as that in Example 3 and further also a product functioning as an ion conductor.

### <Example 8>

The radio wave shielding bodies obtained Examples 4 and 5 were measured for radio wave shielding performance to radio waves in a gigahertz range in the same manner as the above-mentioned method except that each of the radio wave shielding bodies was not sandwiched between acrylic plates as an exterior material. The results are shown in Table 3.

### [Table 3]

**Table 3**

| | | Evaluation in gigahertz range | | | | | | | |
|---|---|---|---|---|---|---|---|---|---|
| | | Reflectance (%) | | | | Absorption rate (%) | | | |
| | | 30GHz | 45GHz | 80GHz | 110GHz | 30GHz | 45GHz | 80GHz | 110GHz |
| Radio wave shielding body in Ex. 4 | With exterior member | 9 | 21 | 8 | 5 | 87 | 77 | 91 | 94 |
| | Without exterior member | 26 | 22 | 26 | 6 | 71 | 76 | 74 | 93 |
| Radio wave shielding body in Ex. 5 | With exterior member | 4 | 16 | 8 | 6 | 65 | 68 | 82 | 89 |
| | Without exterior member | 36 | 17 | 26 | 30 | 47 | 66 | 67 | 66 |

From the results in Table 3, it can be verified that the amount of reflected radio waves was reduced by the exterior material included in the radio wave shielding body. Table 3 also shows the results in the case where the acrylic plate as the exterior material was used.

### <Example 9>

The radio wave shielding body obtained in Example 5 was measured for radio wave shielding performance to radio waves in a gigahertz range (reflection attenuation amount) in the same manner as the above-mentioned method except that the angle of the incident radio wave was changed (tilted at 30° and 60° from the state where the radio wave shielding body faced the traveling direction of the radio wave). The measurement was performed at 30 GHz and 90 GHz. The results are shown in Table 4.

### [Table 4]

**Table 4**

| | Angle of incident radio wave | Transmission attenuation (dB) | |
|---|---|---|---|
| | | 30GHz | 90GHz |
| Radio wave shielding body in Ex. 5 | 0° | -5 | -11.48 |
| | 30° | -18.55 | -35.2 |
| | 60° | -19.08 | -43.22 |

From the results in Table 4, it can be verified that as the angle of the incident radio wave increases, the transmission attenuation amount is increased and the transmitted radio wave is reduced.

### <Example 10>

In Example 5, a graphite-containing radio wave shielding body further containing graphite was produced. Here, graphite is a material which demonstrates radio wave absorbing properties according to a mechanism different from that of the cationic group-containing polymer used in the present invention. Specifically, the graphite-containing radio wave shielding body was produced by the following method.

That is, 5 parts of a (3-acrylamide propyl) trimethylammonium chloride solution (available from Sigma-Aldrich Corporation, 75% by weight aqueous solution), 0.01 parts of tetramethylethylenediamine, and 0.050 parts of a 10% by weight ammonium persulfate aqueous solution were weighed and mixed. Thereafter, 0.05 parts of graphite was added, and was well dispersed by mixing. This mixed solution was left to stand for 24 hours to proceed thermal polymerization under room temperature. Thus, a black sheet-like graphite-containing radio wave shielding body was obtained.

Then, the resulting graphite-containing radio wave shielding body was measured for radio wave shielding performance to radio waves in a gigahertz range (reflection attenuation amount) in the same manner as the above-mentioned method. The measurement was performed at 30 GHz and 90 GHz. The results are shown in Table 5 with the results of measurement of the radio wave shielding body in Example 5.

### [Table 5]

**Table 5**

| | Transmission attenuation (dB) | |
|---|---|---|
| | 30GHz | 90GHz |
| Radio wave shielding body in Ex. 5 | -5 | -11.48 |
| Graphite-containing radio wave shielding body | -21.6 | -16.3 |

From the results in Table 5, it can be verified that the wave radio shielding properties can be further improved by use of graphite in combination with the cationic group-containing polymer, graphite being a material that demonstrates radio wave shielding absorbing properties according to a mechanism different from that of the cationic group-containing polymer.

### <Example 11>

The radio wave shielding bodies obtained in Examples 1 to 5 and Comparative Example 1 were subjected to a burn test. For comparison, an acrylic transparent double-sided pressure-sensitive adhesive sheet (available from Daiso Co., Ltd.) and a polyurethane transparent double-sided pressure-sensitive adhesive sheet (available from Daiso Co., Ltd.) were also subjected to the burn test. The burn test was performed by weighing 100 mg of a liquid sample or cutting the sheet into a sheet-like sample having a weight of 100 mg, placing the sample on a stainless steel dish, applying a flame of a lighter to the sample for 5 seconds, and observing the burning behavior of the sample. The results are shown in Table 6.

### [Table 6]

**Table 6**

| | Burning behavior |
|---|---|
| Radio wave shielding body in Ex. 1 | The surface was burning while a flame was applied, but the burning no longer continued after application of the flame was stopped. |
| Radio wave shielding body in Ex. 2 | |
| Radio wave shielding body in Ex. 3 | |
| Radio wave shielding body in Ex. 4 | |
| Radio wave shielding body in Ex. 5 | |
| Radio wave shielding body in Comp. Ex. 1 | The sheet ignited within 1 second, and the burning continued after the flame was away therefrom. |
| Acrylic sheet | |
| Polyurethane sheet | |

From the results in Table 6, it can be verified that the radio wave shielding bodies containing the cationic group-containing polymer also had high burn resistance.

### <Example 12>

A sheet-like radio wave shielding body (containing 25% by weight of water) comprising a cross-linked product of the side chain ammonium group-containing polymer (B) including the repeating unit represented by Formula (10) above was obtained in the same manner as in Example 5. The thickness of the sheet-like radio wave shielding body was 6 mm.

The resulting sheet-like radio wave shielding body was measured for specific gravity. It was verified that the specific gravity was 1.2 g/cm³, and the sheet-like radio wave shielding body was lighter than conductive carbon (about 1.8 g/cm³) and a magnetic substance (about 4 g/cm³ or more), which are known as radio wave absorption materials. The resulting sheet-like radio wave shielding body was measured for Duro-A hardness according to JIS K 7215-1986. The result was HDA 6, and the sheet-like radio wave shielding body was very soft. The conductive carbon and magnetic substance which are known as radio wave absorption materials are very hard materials and have less flexibility.

### <Example 13>

### (Adhesive sheet)

An adhesive sheet comprising a cross-linked product of the side chain ammonium group-containing polymer (B) including the repeating unit represented by Formula (10) above was obtained in the same manner as in Example 5 except that water was added to the solution obtained by the same method as that in Example 5. In this Example, the polymer weight content was adjusted to 60% by weight, the water content was adjusted to 40% by weight, and the sheet thickness was 6 mm. The resulting adhesive sheet was measured for Duro-A hardness according to JIS K 7215-1986. The result was HDA 0, and the adhesive sheet was very soft.

### <Example 14>

### (Adhesive sheet)

An adhesive sheet comprising a cross-linked product of the side chain ammonium group-containing polymer (B) including the repeating unit represented by Formula (10) above was obtained in the same manner as in Example 5. In this Example, the polymer weight content was adjusted to 75% by weight, the water content was adjusted to 25% by weight, and the thickness was 1 mm. The resulting adhesive sheet was placed on a glass plate, and the blade of a cutter knife was pressed hard onto the adhesive sheet, and was held for 5 seconds. As a result, a trace of the cutter knife pressed was left on the surface of the adhesive sheet, but the adhesive sheet was not cut off and had sufficient strength.

Separately from the adhesive sheet above, an adhesive sheet comprising a cross-linked product of the side chain ammonium group-containing polymer (B), having a polymer weight of 50% by weight, a water content of 50% by weight, and a thickness of 1 mm was obtained through the same operation as above except that water was added. Likewise, the resulting adhesive sheet was placed on a glass plate, and the blade of a cutter knife was pressed hard onto the adhesive sheet, and was held for 5 seconds. It was found that the sheet was cut into two at the place where the cutter knife was pressed, and it had insufficient strength.

### <Example 15>

### (Adhesive sheet)

An adhesive sheet comprising a cross-linked product of the side chain ammonium group-containing polymer (B) including the repeating unit represented by Formula (10) above and having a thickness of 1 mm was obtained in the same manner as in Example 5. In this Example, in which using two glass plates measuring 10 cm × 10 cm × 1 mmt as exterior materials, the adhesive sheet having a thickness of 1 mm prepared above was sandwiched between these glass plates, formation was performed by performing a cross-linking reaction. In this Example, two test samples above were prepared, the ends of the test samples were opened, and were not particularly sealed.

Then, using one of the test samples, the adhesion strength was evaluated. The two glass plates were well bonded, and were not peeled off even if a force was applied to try to peel the two glass plates. When a stronger force was applied, the glass plates were broken.

The other test sample was immersed in a water bath, and was left to stand for 24 hours. The adhesive sheet absorbed water and swelled, and the two glass plates were spontaneously peeled off. From this result, it can be said that the composite material as an adherend can be easily dissembled, and the adhesive according to the present invention can provide a composite material having excellent recycling properties. The swollen adhesive sheet had a thickness three times or larger the original thickness.

### <Example 16>

### (Adhesive sheet)

An adhesive sheet comprising a cross-linked product of poly(diallyldimethylammonium chloride) including the repeating unit represented by Formula (9) above and having a thickness of 1 mm was obtained in the same manner as in Example 4. Also in this Example, as in Example 15, in which using two glass plates measuring 10 cm × 10 cm × 1 mmt as exterior materials, the adhesive sheet having a thickness of 1 mm prepared above was sandwiched between these glass plates, formation was performed by performing a cross-linking reaction. Also in this Example, two test samples above were prepared, and were evaluated as in Example 15. The result of evaluation of the adhesion strength and the result of immersion in the water bath were the same as those in Example 15.

### <Comparative Example 2>

Using 10 cm × 10 cm × 1 mmt acrylic adhesive sheet as an adhesive sheet, two test samples each including the adhesive sheet sandwiched between two glass plates were prepared as in Example 15. Then, the adhesion strength was evaluated as in Example 15. The two glass plates were well bonded, and were not peeled off even if a force was applied to try to peel the two glass plates. When a stronger force was applied, the glass plates were broken. On the other hand, after the test sample was immersed in a water bath and was left to stand for 24 hours as in Example 15, any particular change was not observed, and the glass plate could not be peeled off.

### <Comparative Example 3>

A starch glue was used as a water-soluble adhesive, and a test sample including the starch glue sandwiched between two glass plates was prepared as in Example 15. However, the starch glue was hardly dried even after 24 hours had passed, and the two glass plates were not bonded to each other. For this reason, only the starch glue was slightly extended on a piece of glass, and was dried in that state to form a starch glue layer having a thickness of 1 mm. Then, another glass plate was placed over to try bonding. However, the dried starch glue had neither tackiness nor adhesiveness, and any composite material could not be prepared.

### <Example 17>

### (Adhesive layer)

Cellophane paper was prepared as a substrate, and the solution prepared in Example 15 was applied thereto to form an adhesive layer having a thickness of 50 µm. Then, this was cut into a size of 2 cm × 4 cm to prepare a cellophane tape. Using the resulting cellophane tape, a sheet of copy paper of size A4 was bonded to a wall. The sheet of copy paper was not peeled off even after one year had passed, and maintained favorable adhesion strength. The water content of the tape after one year had passed was 15% or more.

The cellophane paper including the adhesive layer formed above was cut into a size of 2 cm × 15 cm, and was used as a tape for fixing a gauze dressing to an arm of a person. As a result, it was well bonded to both of the gauze dressing and the human body, and functioned well as a tape. When this tape was removed, it spontaneously peeled off by applying water, and no pain in the skin was caused. In contrast, when a commercially available tape was removed likewise, the skin or the hairs were pulled during the removal, causing a pain.

### <Example 18>

### (Adhesive layer)

Two glass slides (7.5 cm × 2.5 cm × 110 µm) were prepared. A few droplets of the solution prepared in Example 5 were added dropwise to a position 1.5 cm from an end of one of the glass slides. One polyethylene film (4-cm square, thickness: 25 µm) was placed thereon, and further, a few droplets of the solution prepared in Example 5 were added dropwise. Finally, the other glass slide was displaced in the length direction and overlaid the workpiece, and was sufficiently pressed thereto so that the solution would not leak from the end. In this example, the two glass slides and the polyethylene film were overlaid such that the length of the overlaid portion was 3 cm (the overlaid area was 3 cm × 2.5 cm). In the next step, polymerization and cross-linking were performed by irradiating the solution added dropwise with UV light at 365 nm, thereby forming an adhesive layer (containing 25% by weight of water) comprising a cross-linked product of the side chain ammonium group-containing polymer (B) including the repeating unit represented by Formula (10) above between the respective layers. In this Example, three test samples above were prepared.

Then, one of the test samples was evaluated for adhesion strength. The two glass plates were well bonded, and were not peeled off even if a force was applied to try to peel the two glass plates. When a stronger force was applied, the glass plates were broken. Another test sample was placed into a domestic microwave oven (600 W, 2.45 GHz), and was heated for 15 seconds. Then, peel-off from polyethylene occurred in the test sample. It is considered that this is because heat generated as a result of absorption of the microwave by the adhesive layer, and water vapors at a high temperature generated, forcing open the interface to cause the peel-off. In this test sample, the temperatures of portions other than the bonding portion were hardly increased, and the test sample could be held by hand. The adhesive cured product left on the glass slide was bonded well. After water was applied thereto, the adhesive cured product immediately swelled, and was removed by wiping with a weak force, which indicates excellent dissembling properties.

Using further another test sample, the bonding portion was heated with a domestic hair dryer (1200 W). Any change was not observed in 15 seconds. After heating for 45 seconds, the glass slide could be peeled off without breaking by applying a force. In the heating with the dryer, portions other than the bonding portion also became hot.

### <Example 19>

### (Adhesive layer)

Three test samples were obtained in the same manner as in Example 18 except that the solution prepared in Example 4 was used, and were evaluated likewise. The same results as those in Example 18 were obtained.

## Claims

1. A radio wave shielding body comprising a cationic group-containing polymer having a cationic group in a polymer chain.

2. The radio wave shielding body according to claim 1, wherein the radio wave shielding body contains the cationic group-containing polymer in a proportion of 1 to 100% by weight.

3. The radio wave shielding body according to claim 1 or 2, wherein the radio wave shielding body shields radio waves with a frequency of 1 GHz or more and 300 THz or less.

4. The radio wave shielding body according to any one of claims 1 to 3, further comprising an exterior member.

5. A sheet comprising the radio wave shielding body according to any one of claims 1 to 4.

6. A partition member comprising the radio wave shielding body according to any one of claims 1 to 4.

7. The partition member according to claim 6, wherein the partition member is a divider, a humidity conditioner, a thermal barrier, a curtain, a window, a wall material, eyeglasses, a housing for an electrical circuit product, or a member used in an inside of an electrical circuit product.

8. A sealing material comprising the radio wave shielding body according to any one of claims 1 to 4.

9. An adhesive composition comprising a cationic group-containing polymer having a cationic group in a polymer chain, and water,
wherein the content of the cationic group-containing polymer in the adhesive composition is 55% by weight or more and 95% by weight or less, and the content of the water in the adhesive composition is 5% by weight or more and 45% by weight or less.

10. The adhesive composition according to claim 9, wherein the adhesive composition is capable of absorbing water in a weight five times or more the weight of the cationic group-containing polymer, thereby making the cationic group-containing polymer swellable or soluble in water.

11. The adhesive composition according to claim 9 or 10, wherein the adhesive composition is curable by performing at least one of polymerization and cross-linking.

12. A molded body obtained by forming a gel of the adhesive composition according to any one of claims 9 to 11.

13. The molded body according to claim 12, wherein the molded body is capable of absorbing water in a weight five times or more the weight of the cationic group-containing polymer, thereby making the cationic group-containing polymer swellable or soluble in water.

14. An adhesive comprising the adhesive composition according to any one of claims 9 to 11 or the molded body according to claim 12 or 13.

15. A composite material obtained by bonding with the adhesive according to claim 14.

16. A composite formation method of forming a first material and a second material into a composite by performing at least one of polymerization and cross-linking in a state where the adhesive composition according to claim 11 is in contact with the first material and the second material.
